# EUROPEAN PATENT APPLICATION

(11) **EP 4 464 711 A1**
(43) Date of publication of application: **20.11.2024**
(21) Application number: 22920652.9
(22) Date of filing: 27.12.2022
(51) Int. Cl.: C07F 5/06, C07F 19/00, C09B 47/08, G03F 7/004, C07F 9/09, C09B 67/20, G02B 5/20

(54) **COMPOUND AND COLORED RESIN COMPOSITION**

(30) Priority: 13.01.2022 JP 2022003768
(71) Applicant: Sumitomo Chemical Company, Limited, Tokyo 103-6020 (JP)
(72) Inventor: AOKI, Takuma, Osaka-shi, Osaka 554-8558 (JP); NAKAYAMA, Tomohiro, Osaka-shi, Osaka 554-8558 (JP)
(74) Representative: Vossius & Partner Patentanwälte Rechtsanwälte mbB
(86) International application number: PCT/JP2022/048178
(87) International publication number: WO 2023/136136

(57) **Abstract**

An object of the present invention is to provide a compound having a high molar absorption coefficient in a maximum absorption wavelength (λmax) within a range of 600 to 750 nm and good stability before and after post-baking when a color filter is produced.

The present invention relates to a compound represented by formula (I): 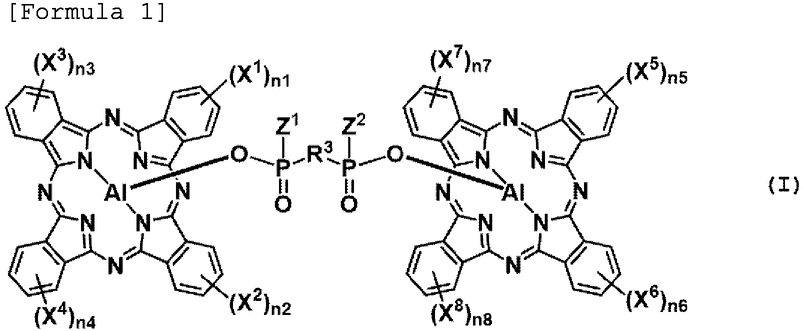 wherein Z¹ and Z² each independently represent a group represented by formula (i), R³ represents a hydrocarbon group optionally having a substituent, an aromatic heterocyclic group optionally having a substituent, or a group in which a hydrocarbon group optionally having a substituent and an aromatic heterocyclic group optionally having a substituent are combined, and -CH₂- contained in the hydrocarbon group is optionally replaced with -O-, -CO-, -NR⁶-, -S-, -SO-, or -SO₂-, 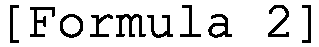 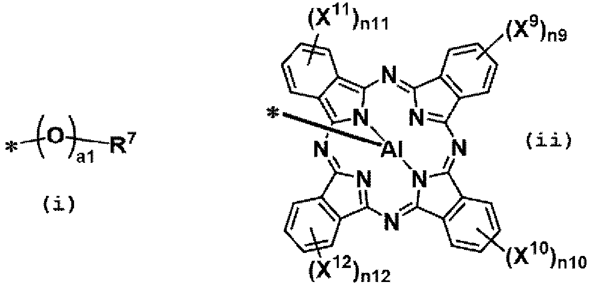 wherein R⁷ represents a hydrogen atom, a hydrocarbon group optionally having a substituent, or a group represented by formula (ii), and a1 represents 0 or 1.

## Description

### Technical Field

The present invention relates to a compound, a colored resin composition, a color filter, and a display device.

### Background Art

A color filter used for display devices such as a liquid crystal display device, an electroluminescence display device, and a plasma display, and solid-state image sensors such as a CCD and a CMOS sensor is produced from a colored resin composition. An aluminum phthalocyanine pigment is known as a colorant for such a colored resin composition. Patent Document 1 discloses that using an aluminum phthalocyanine pigment having a specific structure as a colorant provides a colored composition for a color filter that is excellent in not only NMP (N-methylpyrrolidone) resistance but also developability and flatness of a coating film while having high brightness when the colored composition is used for the color filter.

### Citation List

### Patent Literature

Patent Literature 1: Japanese Patent Laid-Open No. 2016-75837

### Summary of Invention

### Technical Problem

However, the aluminum phthalocyanine pigment disclosed in Patent Document 1 sometimes had a small molar absorption coefficient in a maximum absorption wavelength (λmax) within a range of 600 to 750 nm, and low stability before and after post-baking when a color filter is produced. Then, an object of the present invention is to provide a novel compound having a large molar absorption coefficient in a maximum absorption wavelength (λmax) within a range of 600 to 750 nm and good stability before and after post-baking when a color filter is produced.

### Solution to Problem

The present invention includes the following inventions.
[1] A compound represented by formula (I): 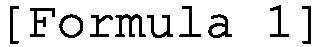 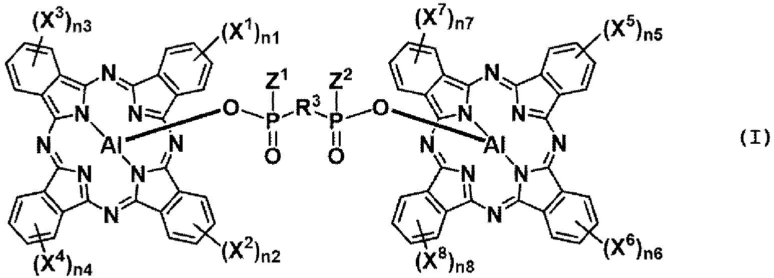 wherein
   X¹ to X⁸ each independently represent -R⁴, -OR⁴, -SR⁴, a halogen atom, a nitro group, or a sulfamoyl group optionally having a substituent,
   R⁴ represents a hydrocarbon group having 1 to 20 carbon atoms and optionally having a substituent,
   n1 to n8 each independently represent an integer of 0 to 4,
   Z¹ and Z² each independently represent a group represented by formula (i),
   R³ represents a hydrocarbon group optionally having a substituent, an aromatic heterocyclic group optionally having a substituent, or a group in which a hydrocarbon group optionally having a substituent and an aromatic heterocyclic group optionally having a substituent are combined, and -CH₂- contained in the hydrocarbon group is optionally replaced with -O-, -CO-, -NR⁶-, -S-, -SO-, or -SO₂-, and
   R⁶ represents a hydrogen atom or an alkyl group having 1 to 4 carbon atoms, 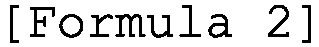 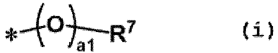 wherein
      R⁷ represents a hydrogen atom, a hydrocarbon group optionally having a substituent, or a group represented by formula (ii),
      a1 represents 0 or 1, and
      * represents a bond, 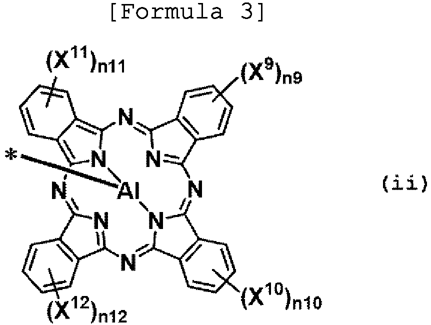 wherein
         X⁹ to X¹² each independently represent -R⁵, -OR⁵, - SR⁵, a halogen atom, a nitro group, or a sulfamoyl group optionally having a substituent,
         R⁵ represents a hydrocarbon group having 1 to 20 carbon atoms and optionally having a substituent,
         n9 to n12 each independently represent an integer of 0 to 4, and
         * represents a bond.
[2] A colored resin composition comprising the compound according to [1] and a resin.
[3] The colored resin composition according to [2], comprising a polymerizable compound and a polymerization initiator.
[4] A color filter formed from the colored resin composition according to [2] or [3].
[5] A display device comprising the color filter according to [4].

### Advantageous Effects of Invention

The present invention can provide a novel compound having a large molar absorption coefficient in a maximum absorption wavelength within a range of 600 to 750 nm, and a color filter formed from a colored resin composition containing the novel compound can have good stability before and after post-baking.

### Description of Embodiments

### <<Compound>>

Hereinafter, the present invention will be described more specifically with reference to the partial structure of a compound represented by formula (I). A novel compound represented by formula (I) according to the present invention has a large molar absorption coefficient in a maximum absorption wavelength within a range of 600 to 750 nm, and a color filter formed from a colored resin composition containing the compound can have good stability before and after post-baking. Furthermore, the novel compound represented by formula (I) has good thermal stability in a preferable aspect.

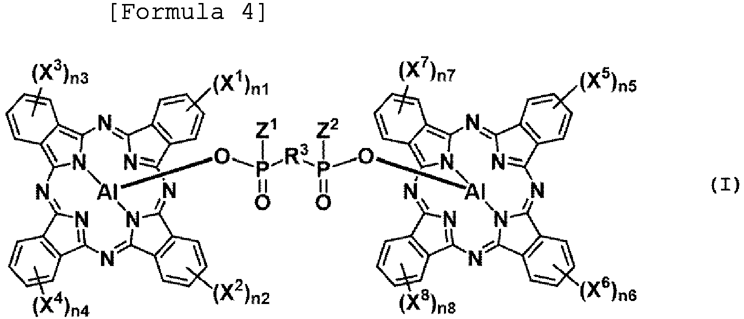

[In formula (I),
X¹ to X⁸ each independently represent -R⁴, -OR⁴, -SR⁴, a halogen atom, a nitro group, or a sulfamoyl group optionally having a substituent.
R⁴ represents a hydrocarbon group having 1 to 20 carbon atoms and optionally having a substituent.
n1 to n8 each independently represent an integer of 0 to 4.
Z¹ and Z² each independently represent a group represented by formula (i).
R³ represents a hydrocarbon group optionally having a substituent, an aromatic heterocyclic group optionally having a substituent, or a group in which a hydrocarbon group optionally having a substituent and an aromatic heterocyclic group optionally having a substituent are combined, and -CH₂- contained in the hydrocarbon group is optionally replaced with -O-, -CO-, -NR⁶-, -S-, -SO-, or -SO₂-.
R⁶ represents a hydrogen atom or an alkyl group having 1 to 4 carbon atoms.]

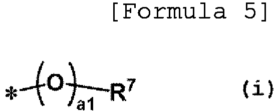

[In formula (i),
R⁷ represents a hydrogen atom, a hydrocarbon group optionally having a substituent, or a group represented by formula (ii).
a1 represents 0 or 1.
* represents a bond.]

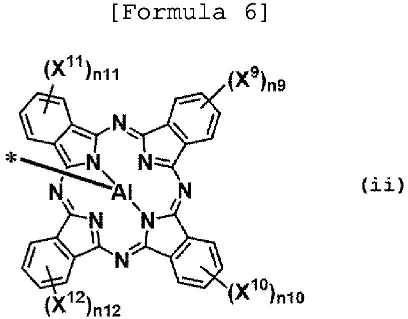

[In formula (ii),
X⁹ to X¹² each independently represent -R⁵, -OR⁵, - SR⁵, a halogen atom, a nitro group, or a sulfamoyl group optionally having a substituent.
R⁵ represents a hydrocarbon group having 1 to 20 carbon atoms and optionally having a substituent.
n9 to n12 each independently represent an integer of 0 to 4.
* represents a bond.]

The hydrocarbon group represented by R⁴ and R⁵ has 1 to 20 carbon atoms, and preferably 1 to 15 carbon atoms.

The hydrocarbon group having 1 to 20 carbon atoms represented by R⁴ and R⁵ is optionally an aliphatic hydrocarbon group or an aromatic hydrocarbon group. The aliphatic hydrocarbon group is optionally saturated or unsaturated, and is optionally chain or cyclic (alicyclic hydrocarbon group).

Examples of the saturated or unsaturated chain hydrocarbon group represented by R⁴ and R⁵ include straight-chain alkyl groups such as a methyl group, an ethyl group, a n-propyl group, a n-butyl group, a n-pentyl group, a n-hexyl group, a n-heptyl group, a n-octyl group, a n-nonyl group, a n-decyl group, a n-undecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, and a n-icosyl group;
branched-chain alkyl groups such as an isopropyl group, an isobutyl group, a sec-butyl group, a tert-butyl group, a 2-ethylbutyl group, 3,3-dimethylbutyl group, a 1,1,3,3-tetrametylbutyl group, a 1-methylbutyl group, a 1-ethylpropyl group, a 3-methylbutyl group, a neopentyl group, a 1,1-dimethylpropyl group, a 2-methylpentyl group, a 3-ethylpentyl group, a 1,3-dimethylbutyl group, a 2-propylpentyl group, a 1-ethyl-1,2-dimethylpropyl group, a 1-methylpentyl group, a 4-methylpentyl group, a 4-methylhexyl group, a 5-methylhexyl group, a 2-ethylhexyl group, a 1-methylhexyl group, a 1-ethylpentyl group, a 1-propylbutyl group, a 3-ethylheptyl group, a 2,2-dimethylheptyl group, a 1-methylheptyl group, a 1-ethylhexyl group, a 1-propylpentyl group, a 1-methyloctyl group, a 1-ethylheptyl group, a 1-propylhexyl group, a 1-butylpentyl group, a 1-methylnonyl group, a 1-ethyloctyl group, a 1-propylheptyl group, and a 1-butylhexyl group;
alkenyl groups such as an ethenyl group (a vinyl group), a propenyl group (for example, a 1-propenyl group and a 2-propenyl group (an allyl group)), a 1-methylethenyl group, a butenyl group (for example, a 1-butenyl group, a 2-butenyl group, and a 3-butenyl group), a 3-methyl-1-butenyl group, a 1-methyl-1-butenyl group, a 3-methyl-2-butenyl group, a 1,3-butadienyl group, a 3-methyl-1,2-butadienyl group, a 1-(2-propenyl)ethenyl group, a 1-(1-methylethenyl)ethenyl group, a 1,1-dimethyl-2-propenyl group, a 1,2-dimethyl-1-propenyl group, a 1-ethyl-2-propenyl group, a pentenyl group (for example, a 1-pentenyl group, a 2-pentenyl group, a 3-pentenyl group, and a 4-pentenyl group), a 1-(1,1-dimethylethyl)ethenyl group, a 1,3-dimethyl-1-butenyl group, a hexenyl group (for example, a 1-hexenyl group and a 5-hexenyl group), a heptenyl group (for example, a 1-heptenyl group and a 6-heptenyl group), an octenyl group (for example, a 1-octenyl group and a 7-octenyl group), a nonenyl group (for example, a 1-nonenyl group and a 8-nonenyl group), a decenyl group (for example, a 1-decenyl group and a 9-decenyl group), an undecenyl group, a dodecenyl group, a tridecenyl group, a tetradecenyl group, a pentadecenyl group, a hexadecenyl group, a heptadecenyl group, an octadecenyl group, a nonadecenyl group, and an icosenyl group; and
alkynyl groups such as an ethynyl group, a propynyl group (for example, a 1-propynyl group and a 2-propynyl group), a butynyl group (for example, a 1-butynyl group, a 2-butynyl group, and a 3-butynyl group), a pentynyl group (for example, a 2-pentynyl group, a 3-pentynyl group, and a 4-pentynyl group), a 1-methyl-3-butynyl group, a 1,1-dimethyl-2-propynyl group, a hexynyl group (for example, a 2-hexynyl group and a 5-hexynyl group), a 1-ethyl-3-butynyl group, a heptynyl group (for example, a 2-heptynyl group and a 6-heptynyl group), a 1-ethyl-3-pentynyl group, an octynyl group (for example, a 1-octynyl group, a 2-octynyl group, and a 7-octynyl group), a nonynyl group (for example, a 2-nonynyl group and a 8-nonynyl group), a decynyl group (for example, a 2-decynyl group and a 9-decynyl group), an undecynyl group, a dodecynyl group, a tridecynyl group, a tetradecynyl group, a pentadecynyl group, a hexadecynyl group, a heptadecynyl group, an octadecynyl group, a nonadecynyl group, and an icosynyl group.

The saturated chain hydrocarbon group (namely, straight-chain alkyl group and branched-chain alkyl group) represented by R⁴ and R⁵ preferably has 1 to 10 carbon atoms, more preferably 1 to 7 carbon atoms, and still more preferably 1 to 5 carbon atoms.

The unsaturated chain hydrocarbon group (namely, alkenyl group and alkynyl group) represented by R⁴ and R⁵ preferably has 2 to 10 carbon atoms, more preferably 2 to 7 carbon atoms, and still more preferably 2 to 5 carbon atoms.

Examples of the saturated or unsaturated alicyclic hydrocarbon group represented by R⁴ and R⁵ include cycloalkyl groups such as a cyclopropyl group, a 1-methylcyclopropyl group, a cyclobutyl group, a cyclopentyl group, a cyclohexyl group, a cycloheptyl group, a 1-methylcyclohexyl group, a 2-methylcyclohexyl group, a 3-methylcyclohexyl group, a 4-methylcyclohexyl group, a 1,2-dimethylcyclohexyl group, a 1,3-dimethylcyclohexyl group, a 1,4-dimethylcyclohexyl group, a 2,3-dimethylcyclohexyl group, a 2,4-dimethylcyclohexyl group, a 2,5-dimethylcyclohexyl group, a 2,6-dimethylcyclohexyl group, a 3,4-dimethylcyclohexyl group, a 3,5-dimethylcyclohexyl group, a 2,2-dimethylcyclohexyl group, a 3,3-dimethylcyclohexyl group, a 4,4-dimethylcyclohexyl group, a cyclooctyl group, a 2,4,6-trimethylcyclohexyl group, a 2,2,6,6-tetramethylcyclohexyl group, a 3,3,5,5-tetramethylcyclohexyl group, a 4-pentylcyclohexyl group, a 4-octylcyclohexyl group, and a 4-cyclohexylcyclohexyl group;
cycloalkenyl groups such as a cyclohexenyl group (for example, a cyclohexa-1-en-1-yl group, a cyclohexa-2-en-1-yl group, and a cyclohexa-3-en-1-yl group), a cycloheptenyl group, and a cyclooctenyl group; and
saturated or unsaturated polycyclic hydrocarbon groups such as a norbornyl group, a norbornenyl group, an adamantly group, and a bicyclo[2.2.2]octyl group.

The saturated or unsaturated alicyclic hydrocarbon group represented by R⁴ and R⁵ preferably has 3 to 10 carbon atoms.

Examples of the aromatic hydrocarbon group represented by R⁴ and R⁵ include a phenyl group, an o-tolyl group, a m-tolyl group, a p-tolyl group, a 2-ethylphenyl group, a 3-ethylphenyl group, a 4-ethylphenyl group, a 2,3-dimethylphenyl group, a 2,4-dimethylphenyl group, a 2,5-dimethylphenyl group, a 2,6-dimethylphenyl group, a 3,4-dimethylphenyl group, a 3,5-dimethylphenyl group, a 4-vinylphenyl group, an o-isopropylphenyl group, a m-isopropylphenyl group, a p-isopropylphenyl group, an o-tert-butylphenyl group, a m-tert-butylphenyl group, a p-tert-butylphenyl group, a 3,5-di(tert-butyl)phenyl group, a 3,5-di(tert-butyl)-4-methylphenyl group, a 4-butylphenyl group, a 4-pentylphenyl group, a 2,6-bis(1-methylethyl)phenyl group, a 2,4,6-tris(1-methylethyl)phenyl group, a 4-cyclohexylphenyl group, a 2,4,6-trimethylphenyl group, a 4-octylphenyl group, a 4-(1,1,3,3-tetramethylbutyl)phenyl group, a 1-naphthyl group, a 2-naphthyl group, a 6-methyl-2-naphthyl group, a 5,6,7,8-tetrahydro-1-naphthyl group, a 5,6,7,8-tetrahydro-2-naphthyl group, a fluorenyl group, a phenanthryl group, an anthryl group, a 2-dodecylphenyl group, a 3-dodecylphenyl group, a 4-dodecylphenyl group, a perylenyl group, a chrysenyl group, and a pyrenyl group.

The aromatic hydrocarbon group represented by R⁴ and R⁵ preferably has 6 to 20 carbon atoms, more preferably 6 to 10 carbon atoms, and still more preferably 6 to 8 carbon atoms.

The hydrocarbon group represented by R⁴ and R⁵ is optionally a group in which the above-mentioned hydrocarbon groups (for example, an aromatic hydrocarbon group and at least one of a chain hydrocarbon group and an alicyclic hydrocarbon group) are combined.

Examples of thereof include aralkyl groups such as a benzyl group, a (2-methylphenyl)methyl group, a (3-methylphenyl)methyl group, a (4-methylphenyl)methyl group, a (2-ethylphenyl)methyl group, a (3-ethylphenyl)methyl group, a (4-ethylphenyl)methyl group, a (2-(tert-butyl)phenyl)methyl group, a (3-(tert-butyl)phenyl)methyl group, a (4-(tert-butyl)phenyl)methyl group, a (3,5-dimethylphenyl)methyl group, a 1-phenylethyl group, a 1-methyl-1-phenylethyl group, a 1,1-diphenylethyl group, a (1-naphthyl)methyl group, and a (2-naphthyl)methyl group;
arylalkenyl groups such as a 1-phenylethenyl group, a 2-phenylethenyl group (a phenylvinyl group), a 2,2-diphenylethenyl group, and a 2-phenyl-2-(1-naphthyl)ethenyl group;
arylalkynyl groups such as a phenylethynyl group and a 3-phenyl-2-propynyl group;
phenyl groups with one or more phenyl groups bonded, such as a biphenylyl group and a terphenylyl group; and
a cyclohexylmethylphenyl group, a benzylphenyl group, and a (dimethyl(phenyl)methyl)phenyl group.

These groups each preferably have 7 to 18 carbon atoms, and more preferably 7 to 15 carbon atoms.

The group represented by R⁴ and R⁵ is also optionally a group in which the above-mentioned hydrocarbon groups (for example, a chain hydrocarbon group and an alicyclic hydrocarbon group) are combined. Examples of thereof include alkyl groups with one or more alicyclic hydrocarbon groups bonded, such as a cyclopropylmethyl group, a cyclopropylethyl group, a cyclobutylmethyl group, a cyclobutylethyl group, a cyclopentylmethyl group, a cyclopentylethyl group, a cyclohexylmethyl group, a (2-methylcyclohexyl)methyl group, a cyclohexylethyl group, and an adamantylmethyl group.

These groups each preferably have 4 to 15 carbon atoms, and more preferably 4 to 10 carbon atoms.

The hydrocarbon group having 1 to 20 carbon atoms represented by R⁴ and R⁵ optionally has a substituent.

Examples of the substituent of the hydrocarbon group having 1 to 20 carbon atoms represented by R⁴ and R⁵ include a heterocyclic group optionally having a substituent, a halogen atom, a nitro group, a cyano group, -OR^{a1}, -CO2R^{a1}, -SR^{a1}, -SO₂R^{a1}, -SO₃R^{a1}, -SO₂NR^{a1}R^{a2}, and -NR^{a1}R^{a2}.

Here, R^{a1} and R^{a2} each independently represent a hydrogen atom or a hydrocarbon group having 1 to 20 carbon atoms. The hydrocarbon group having 1 to 20 carbon atoms represented by R^{a1} and R^{a2} is the same as the hydrocarbon group having 1 to 20 carbon atoms represented by R⁴ and R⁵. R^{a1} and R^{a2} are each independently a hydrogen atom, a saturated chain hydrocarbon group having 1 to 10 carbon atoms, or an aromatic hydrocarbon group having 6 to 10 carbon atoms.

The heterocyclic group used as the substituent of the hydrocarbon group having 1 to 20 carbon atoms represented by R⁴ and R⁵ is optionally monocyclic or polycyclic, and is preferably a heterocycle containing a heteroatom as a constituent element of its ring. Examples of the heteroatom include a nitrogen atom, an oxygen atom, and a sulfur atom.

Examples of a heterocycle containing only nitrogen atom(s) as the heteroatom include monocyclic saturated heterocycles such as aziridine, azetidine, pyrrolidine, piperidine, and piperazine; 5-membered unsaturated heterocycles such as pyrrole, pyrazole, imidazole, 1,2,3-triazole, and 1,2,4-triazole; 6-membered unsaturated heterocycles such as pyridine, pyridazine, pyrimidine, pyrazine, and 1,3,5-triazine; fused bicyclic heterocycles such as indazole, indoline, isoindoline, isoindoline-1,3-dione, indole, indolizine, benzimidazole, quinoline, isoquinoline, quinoxaline, quinazoline, cinnoline, phthalazine, naphthyridine, purine, pteridine, benzopyrazole, and benzopiperidine; and fused tricyclic heterocycles such as carbazole, acridine, and phenazine.

Examples of a heterocycle containing only oxygen atom(s) as the heteroatom include monocyclic saturated heterocycles such as oxirane, oxetane, tetrahydrofuran, tetrahydropyran, 1,3-dioxane, and 1,4-dioxane; bicyclic saturated heterocycles such as 1,4-dioxaspiro[4.5]decane and 1,4-dioxaspiro[4.5]nonane; lactone heterocycles such as **α**-acetolactone, **β**-propiolactone, **γ**-butyrolactone, and **σ**-valerolactone; 5-membered unsaturated heterocycles such as furan; 6-membered unsaturated heterocycles such as 2H-pyran and 4H-pyran; fused bicyclic heterocycles such as 1-benzofuran, benzopyran, benzodioxole, chroman, and isochroman; and fused tricyclic heterocycles such as xanthene and dibenzofuran.

Examples of a heterocycle containing only sulfur atom(s) as the heteroatom include 5-membered saturated heterocycles such as dithiolane; 6-membered saturated heterocycles such as thiane and 1,3-dithiane; 5-membered unsaturated heterocycles such as thiophene; 6-membered unsaturated heterocycles such as 4H-thiopyran; fused bicyclic heterocycles such as benzothiopyran including benzotetrahydrothiopyran and the like, and benzothiophene; and fused tricyclic heterocycles such as thianthrene and dibenzothiophene.

Examples of a heterocycle containing nitrogen atom(s) and oxygen atom(s) as the heteroatom include monocyclic saturated heterocycles such as morpholine, 2-pyrrolidone, and 2-piperidone; monocyclic unsaturated heterocycles such as oxazole and isoxazole; fused bicyclic heterocycles such as benzoxazole, benzoisoxazole, benzoxazine, benzodioxane, and benzimidazoline; and fused tricyclic heterocycles such as phenoxazine.

Examples of a heterocycle containing nitrogen atom(s) and sulfur atom(s) as the heteroatom include monocyclic heterocycles such as thiazole; fused bicyclic heterocycles such as benzothiazole; and fused tricyclic heterocycles such as phenothiazine.

The heterocyclic group preferably has 2 to 30 carbon atoms, more preferably 3 to 22 carbon atoms, and still more preferably 3 to 20 carbon atoms.

The heterocyclic group optionally has a substituent. Examples of the substituent include halogen atoms such as a fluorine atom, a chlorine atom, a bromine atom, and an iodine atom, a nitro group, a cyano group, -OR^{a1}, -CO2R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The bonding position of the heterocycle is at a portion where any hydrogen atom contained in each ring is eliminated.

Examples of the halogen atom used as the substituent of the hydrocarbon group having 1 to 20 carbon atoms represented by R⁴ and R⁵ include a fluorine atom, a chlorine atom, a bromine atom, and an iodine atom.

Examples of the halogen atom represented by X¹ to X¹² include a fluorine atom, a chlorine atom, a bromine atom, and an iodine atom, and among these, a fluorine atom is preferable.

The sulfamoyl group represented by X¹ to X¹² is represented by *-SO₂-NH₂ (* means a bond) .

The sulfamoyl group represented by X¹ to X¹² optionally has a substituent. Examples of the substituent of the sulfamoyl group represented by X¹ to X¹² include a hydrocarbon group having 1 to 20 carbon atoms and optionally having a substituent, a heterocyclic group optionally having a substituent, halogen atoms such as a fluorine atom, a chlorine atom, a bromine atom, and an iodine atom, a nitro group, a cyano group, -OR^{a1}, - CO₂R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

Examples of the hydrocarbon group having 1 to 20 carbon atoms used as the substituent of the sulfamoyl group represented by X¹ to X¹² include the groups exemplified as the hydrocarbon group having 1 to 20 carbon atoms represented by R⁴ and R⁵. The hydrocarbon group having 1 to 20 carbon atoms used as the substituent of the sulfamoyl group represented by X¹ to X¹² is preferably a saturated chain hydrocarbon group having 1 to 10 carbon atoms or an aromatic hydrocarbon group having 6 to 10 carbon atoms, and more preferably a saturated chain hydrocarbon group having 1 to 4 carbon atoms or an aromatic hydrocarbon group having 6 to 8 carbon atoms.

The hydrocarbon group optionally has a substituent. Examples of the substituent include halogen atoms such as a fluorine atom, a chlorine atom, a bromine atom, and an iodine atom, a nitro group, a cyano group, -OR^{a1}, -CO2R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The heterocyclic group used as the substituent of the sulfamoyl group represented by X¹ and X¹² is optionally monocyclic or polycyclic, and is preferably a heterocycle containing a heteroatom as a constituent element of its ring. Examples of the heteroatom include a nitrogen atom, an oxygen atom, and a sulfur atom.

Examples of the heterocycle include the same heterocyclic groups as those used as the substituent of the hydrocarbon group having 1 to 20 carbon atoms represented by R⁴ and R⁵.

The heterocyclic group preferably has 2 to 30 carbon atoms, more preferably 3 to 22 carbon atoms, and still more preferably 3 to 20 carbon atoms.

The heterocyclic group optionally has a substituent. Examples of the substituent include halogen atoms such as a fluorine atom, a chlorine atom, a bromine atom, and an iodine atom, a nitro group, a cyano group, -OR^{a1}, -CO₂R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The bonding position of the heterocycle is at a portion where any hydrogen atom contained in each ring is eliminated.

-R⁴ represented by X¹ to X⁸ and -R⁵ represented by X⁹ to X¹² are preferably an aliphatic hydrocarbon group having 1 to 20 carbon atoms, more preferably a saturated chain hydrocarbon group having 1 to 20 carbon atoms, still more preferably a saturated chain hydrocarbon group having 1 to 10 carbon atoms, yet still more preferably a branched-chain alkyl group having 1 to 5 carbon atoms, and particularly preferably a tert-butyl group.

Preferably, R⁴ and R⁵ in OR⁴ and -SR⁴ represented by X¹ to X⁸ and -OR⁵ and -SR⁵ represented by X⁹ to X¹² are each independently an aliphatic hydrocarbon group having 1 to 20 carbon atoms or an aromatic hydrocarbon group having 6 to 20 carbon atoms, more preferably a saturated chain hydrocarbon group having 1 to 10 carbon atoms or an aromatic hydrocarbon group having 6 to 10 carbon atoms, and still more preferably a straight-chain or branched-chain alkyl group having 1 to 5 carbon atoms or an aromatic hydrocarbon group having 6 to 8 carbon atoms.

Z¹ and Z² each independently represent a group represented by formula (i). In the compound represented by formula (I), Z¹ and Z² are optionally the same or different, but are preferably the same group.

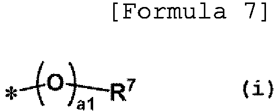

[In formula (i),
R⁷ represents a hydrogen atom, a hydrocarbon group optionally having a substituent, or a group represented by formula (ii).
a1 represents 0 or 1.
* represents a bond.]

The hydrocarbon group represented by R⁷ preferably has 1 to 20 carbon atoms, and more preferably 1 to 15 carbon atoms.

Examples of the hydrocarbon group represented by R⁷ include the same groups as those exemplified as the hydrocarbon group having 1 to 20 carbon atoms represented by R⁴ and R⁵. Namely, examples of the hydrocarbon group represented by R⁷ include chain hydrocarbon groups such as a straight-chain or branched-chain alkyl group, alkenyl group, and alkynyl group; alicyclic hydrocarbon groups such as a cycloalkyl group, a cycloalkenyl group, and a saturated or unsaturated polycyclic hydrocarbon group; an aromatic hydrocarbon group; a group in which an aromatic hydrocarbon group, and at least one of an aromatic hydrocarbon group, a chain hydrocarbon group, and an alicyclic hydrocarbon group are combined; and a chain hydrocarbon group, and an alicyclic hydrocarbon group.

The hydrocarbon group represented by R⁷ optionally has a substituent, and examples of the substituent include a heterocyclic group optionally having a substituent, a halogen atom, a nitro group, a cyano group, -OR^{a1}, -CO₂R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The heterocyclic group used as the substituent of the hydrocarbon group represented by R⁷ is optionally monocyclic or polycyclic, and is preferably a heterocycle containing a heteroatom as a constituent element of its ring. Examples of the heteroatom include a nitrogen atom, an oxygen atom, and a sulfur atom.

Examples of the heterocycle include the same heterocyclic groups as those used as the substituent of the hydrocarbon group having 1 to 20 carbon atoms represented by R⁴ and R⁵.

The heterocyclic group preferably has 2 to 30 carbon atoms, more preferably 3 to 22 carbon atoms, and still more preferably 3 to 20 carbon atoms.

The heterocyclic group optionally has a substituent. Examples of the substituent include halogen atoms such as a fluorine atom, a chlorine atom, a bromine atom, and an iodine atom, a nitro group, a cyano group, -OR^{a1}, -CO₂R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The bonding position of the heterocycle is at a portion where any hydrogen atom contained in each ring is eliminated.

Examples of the halogen atom used as the substituent of the hydrocarbon group represented by R⁷ include a fluorine atom, a chlorine atom, a bromine atom, and an iodine atom.

The hydrocarbon group represented by R³ preferably has 1 to 30 carbon atoms, more preferably 1 to 20 carbon atoms, and still more preferably 2 to 20 carbon atoms.

The hydrocarbon group represented by R³ is optionally a divalent hydrocarbon group. The hydrocarbon group is optionally an aliphatic hydrocarbon group or an aromatic hydrocarbon group, and the aliphatic hydrocarbon group is optionally a chain hydrocarbon group, or an alicyclic hydrocarbon group. The hydrocarbon group is optionally a hydrocarbon group in which two or more of the groups are combined.

Examples of the chain hydrocarbon group include an alkanediyl group, an alkenediyl group, and an alkynediyl group.

Examples of the alkanediyl group include straight-chain alkanediyl groups such as a methylene group, an ethylene group, a propane-1,3-diyl group, a butane-1,4-diyl group, a pentane-1,5-diyl group, a hexane-1,6-diyl group, a heptane-1,7-diyl group, an octane-1,8-diyl group, a nonane-1,9-diyl group, a decane-1,10-diyl group, an undecane-1,11-diyl group, and a dodecane-1,12-diyl group; and
branched alkanediyl groups such as an ethane-1,1-diyl group, a propane-1,1-diyl group, a propane-1,2-diyl group, a propane-2,2-diyl group, a pentane-2,4-diyl group, a 2-methyl propane-1,3-diyl group, a 2-methyl propane-1,2-diyl group, a pentane-1,4-diyl group, and a 2-methylbutane-1,4-diyl group.

The alkanediyl group preferably has 1 to 20 carbon atoms, and more preferably 1 to 10 carbon atoms.

Examples of the alkenediyl group include an ethene-1,1-diyl group, an ethene-1,2-diyl group, a propene-1,2-diyl group, a propene-1,3-diyl group, a propene-2,3-diyl group, a 1-butene-1,2-diyl group, a 1-butene-1,3-diyl group, a 1-butene-1,4-diyl group, a 1-pentene-1,5-diyl group, a 2-pentene-1,5-diyl group, a 1-hexene-1,6-diyl group, a 3-hexene-1,6-diyl group, a 1-heptene-1,7-diyl group, a 1-octene-1,8-diyl group, a 1-nonene-1,9-diyl group, and a 1-decene-1,10-diyl group.

The alkenediyl group preferably has 2 to 20 carbon atoms, and more preferably 2 to 10 carbon atoms.

Examples of the alkynediyl group include an ethyne-1,2-diyl group, a 1-propyne-1,3-diyl group, a 1-butyne-1,4-diyl group, a 2-butyne-1,4-diyl group, a 1-pentyne-1,5-diyl group, a 1-hexyne-1,6-diyl group, a 1-heptyne-1,7-diyl group, a 1-octyne-1,8-diyl group, a 1-nonyne-1,9-diyl group, and a 1-decyne-1,10-diyl group.

The alkynediyl group preferably has 2 to 20 carbon atoms, and more preferably 2 to 10 carbon atoms.

Examples of the alicyclic hydrocarbon group include
cycloalkanediyl groups such as a cyclobutene-1,3-diyl group, a cyclopentane-1,3-diyl group, a cyclohexane-1,4-diyl group, and a cyclooctane-1,5-diyl group;
cycloalkenediyl groups such as a cyclohexene-3,6-diyl group; and
polycyclic hydrocarbon groups such as a norbornane-1,4-diyl group, a norbornane-2,5-diyl group, a 5-norbornene-2,3-diyl group, an adamantane-1,5-diyl group, and an adamantane-2,6-diyl group.

The alicyclic hydrocarbon group preferably has 3 to 18 carbon atoms, more preferably 3 to 16 carbon atoms, and, still more preferably are 3 to 12 carbon atoms.

Examples of the aromatic hydrocarbon group include
phenylene groups such as a 1,2-phenylene group, a 1,3-phenylene group, and a 1,4-phenylene group;
naphthylene groups such as a 1,4-naphthylene group and a 2,6-naphthylene group;
anthrylene groups such as a 1,4-anthrylene group and a 1,8-anthrylene group;
biphenylene groups such as a biphenyl-4,2'-diyl group, a biphenyl-4,3'-diyl group, and a biphenyl-4,4'-diyl group;
phenanthrene groups such as a 2,7-phenanthrene group and a 9,10-phenanthrene group;
fluorenediyl groups such as fluorene-2,7-diyl.

A group in which a hydrogen atom bonded to an aromatic hydrocarbon ring constituting the aromatic hydrocarbon group is replaced with an alkyl group such as a methyl group, an ethyl group, a n-propyl group, an isopropyl group, a n-butyl group, a sec-butyl group, a tert-butyl group, a n-hexyl group, or a 2-ethylhexyl group (preferably an alkyl group having 1 to 8 carbon atoms, and more preferably an alkyl group having 1 to 4 carbon atoms) is also included in the aromatic hydrocarbon group. Examples of the group in which a hydrogen atom bonded to an aromatic hydrocarbon ring constituting the aromatic hydrocarbon group is replaced with an alkyl group include a 4-alkyl-1,3-phenylene group, a 2-alkyl-1,4-phenylene group, a 2,5-dialkyl-1,4-phenylene group, a 2,6-dialkyl-1,4-phenylene group, and 9,9-dialkyl-fluorene-2,7-diyl.

The aromatic hydrocarbon group preferably has 6 to 20 carbon atoms, and more preferably 6 to 15 carbon atoms.

Examples of the hydrocarbon group in which two or more of the groups are combined include a group in which a chain hydrocarbon group, and an alicyclic hydrocarbon group and/or an aromatic hydrocarbon group are combined. In the combination, the chain hydrocarbon groups, the alicyclic hydrocarbon groups, and the aromatic hydrocarbon groups are optionally two or more kinds.

Examples of the hydrocarbon group in which two or more of the groups are combined include *-alicyclic hydrocarbon group-chain hydrocarbon group-**, *-chain hydrocarbon group-alicyclic hydrocarbon group-**, *-chain hydrocarbon group-alicyclic hydrocarbon group-chain hydrocarbon group-**, *-chain hydrocarbon group-aromatic hydrocarbon group-**, *-aromatic hydrocarbon group-chain hydrocarbon group-**, *-chain hydrocarbon group-aromatic hydrocarbon group-chain hydrocarbon group-**, *-aromatic hydrocarbon group-chain hydrocarbon group-aromatic hydrocarbon group-**, and *-chain hydrocarbon group-aromatic hydrocarbon group-chain hydrocarbon group-aromatic hydrocarbon group-chain hydrocarbon group-**. * represents a bond with a phosphorus atom to which Z¹ is bonded, and ** represents a bond with a phosphorus atom to which Z² is bonded.

When the hydrocarbon group has two or more carbon atoms, and contains -CH₂-, -CH₂- contained in the hydrocarbon group is optionally replaced with -O-, -CO-, -NR⁶-, -S-, -SO-, or -SO₂-. The number of (-CH₂-)s replaced with -O-, -CO-, -NR⁶-, -S-, -SO-, or -SO₂- is not particularly limited, and is optionally one or plural. However, when the hydrocarbon group contains only an alkanediyl group, all (-CH₂-)s are not replaced with -O-, -CO-, -NR⁶-, -S-, -SO-, or -SO₂-.

Examples of the alkyl group having 1 to 4 carbon atoms represented by R⁶ include a methyl group, an ethyl group, a n-propyl group, an isopropyl group, a n-butyl group, a sec-butyl group, and a tert-butyl group.

The hydrocarbon group represented by R³ is optionally a substituent, and examples of the substituent include an aromatic heterocyclic group optionally having a substituent, a halogen atom, a nitro group, and a cyano group.

The aromatic heterocyclic group used as the substituent of the hydrocarbon group represented by R³ is optionally monocyclic or polycyclic.

Examples of the aromatic heterocycle include nitrogen-containing aromatic heterocycles containing only a nitrogen atom as a heteroatom, such as a pyrrole ring, a pyrazole ring, an imidazole ring, a pyridine ring, a pyrimidine ring, a pyridazine ring, a pyrazine ring, an indole ring, a benzimidazole ring, a quinoline ring, and an isoquinoline ring; oxygen-containing aromatic heterocycles containing only an oxygen atom as a heteroatom, such as a furan ring and a benzofuran ring; sulfur-containing aromatic heterocycles containing only a sulfur atom as a heteroatom, such as a thiophene ring and a benzothiophene ring; aromatic heterocycles containing a nitrogen atom and an oxygen atom as a heteroatom, such as an oxazole ring; and aromatic heterocyclic groups containing a nitrogen atom and a sulfur atom as a heteroatom, such as a thiazole ring and a benzothiazole ring.

The aromatic heterocyclic group optionally has a substituent, and examples of the substituent include halogen atoms such as a fluorine atom, a chlorine atom, a bromine atom, and an iodine atom, a nitro group, a cyano group, -OR^{a1}, -CO₂R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

The bonding position of the aromatic heterocyclic group is at a portion where any hydrogen atom contained in each ring is eliminated.

Examples of the halogen atom used as the substituent of the hydrocarbon group represented by R³ include a fluorine atom, a chlorine atom, a bromine atom, and an iodine atom.

The aromatic heterocyclic group represented by R³ is a divalent aromatic heterocyclic group, and means the remaining atomic group except two hydrogen atoms directly bonded to an atom constituting a ring from an aromatic heterocyclic group.

The aromatic heterocycle is optionally monocyclic or polycyclic, and examples thereof include
nitrogen-containing aromatic heterocycles containing only a nitrogen atom as a heteroatom, such as a pyrrole ring, a pyrazole ring, an imidazole ring, a pyridine ring, a pyrimidine ring, a pyridazine ring, a pyrazine ring, an indole ring, a benzimidazole ring, a quinoline ring, and an isoquinoline ring;
aromatic heterocycles containing only an oxygen atom as a heteroatom, such as a furan ring and a benzofuran ring;
oxygen-containing aromatic heterocycles containing only a sulfur atom as a heteroatom, such as a thiophene ring and a benzothiophene ring;
sulfur-containing aromatic heterocycles containing a nitrogen atom and an oxygen atom as a heteroatom, such as an oxazole ring; and
aromatic heterocycles containing a nitrogen atom and a sulfur atom as a heteroatom, such as a thiazole ring and a benzothiazole ring.

The bonding position of the aromatic heterocyclic group is at a portion where any two hydrogen atoms contained in each ring are eliminated.

The aromatic heterocyclic group represented by R³ optionally has a substituent, and examples of the substituent include a hydrocarbon group having 1 to 20 carbon atoms and optionally having a substituent, a halogen atom, a nitro group, and a cyano group.

Examples of the hydrocarbon group having 1 to 20 carbon atoms used as the substituent of the aromatic heterocyclic group represented by R³ include the groups exemplified as the hydrocarbon group having 1 to 20 carbon atoms represented by R⁴ and R⁵. The hydrocarbon group having 1 to 20 carbon atoms used as the substituent of the aromatic heterocyclic group represented by R³ is preferably a saturated chain hydrocarbon group having 1 to 10 carbon atoms or an aromatic hydrocarbon group having 6 to 10 carbon atoms, and more preferably a saturated chain hydrocarbon group having 1 to 4 carbon atoms or an aromatic hydrocarbon group having 6 to 8 carbon atoms.

The hydrocarbon group optionally has a substituent, and examples of the substituent include halogen atoms such as a fluorine atom, a chlorine atom, a bromine atom, and an iodine atom, a nitro group, a cyano group, -OR^{a1}, -CO2R^{a1}, -SR^{a1}, -SO₂R^{a1}, -SO₃R^{a1}, -SO₂NR^{a1}R^{a2}, and -NR^{a1}R^{a2}, wherein R^{a1} and R^{a2} are the same as mentioned above.

Examples of the halogen atom used as the substituent of the aromatic heterocyclic group represented by R³ include a fluorine atom, a chlorine atom, a bromine atom, and an iodine atom.

Examples of the group in which the hydrocarbon group optionally having a substituent and the aromatic heterocyclic group optionally having a substituent are combined include a group in which the hydrocarbon group optionally having a substituent represented by R³ and the aromatic heterocyclic group optionally having a substituent represented by R³ are combined. In the combination, the hydrocarbon groups and the aromatic heterocyclic groups are optionally two or more kinds.

Examples of the group in which the hydrocarbon group optionally having a substituent and the aromatic heterocyclic group optionally having a substituent are combined include
*-hydrocarbon group optionally having a substituent-aromatic heterocyclic group optionally having a substituent-**, *-aromatic heterocyclic group optionally having a substituent-hydrocarbon group optionally having a substituent-**, *-hydrocarbon group optionally having a substituent-aromatic heterocyclic group optionally having a substituent-hydrocarbon group optionally having a substituent-**, *-aromatic heterocyclic group optionally having a substituent-hydrocarbon group optionally having a substituent-aromatic heterocyclic group optionally having a substituent-**, and *-hydrocarbon group optionally having a substituent-aromatic heterocyclic group optionally having a substituent-hydrocarbon group optionally having a substituent-aromatic heterocyclic group optionally having a substituent-hydrocarbon group optionally having a substituent-**. Among these, *-hydrocarbon group optionally having a substituent-aromatic heterocyclic group optionally having a substituent-hydrocarbon group optionally having a substituent-** is preferable, and *-chain hydrocarbon group optionally having a substituent-aromatic heterocyclic group optionally having a substituent-chain hydrocarbon group optionally having a substituent-** is more preferable. * represents a bond with a phosphorus atom to which Z¹ is bonded, and ** represents a bond with a phosphorus atom to which Z² is bonded.

X¹ to X⁸ are preferably each independently -R⁴, - OR⁴, or a halogen atom, more preferably a saturated chain hydrocarbon group having 1 to 20 carbon atoms, an alkoxy group having 1 to 20 carbon atoms, or a halogen atom, still more preferably a saturated chain hydrocarbon group having 1 to 10 carbon atoms, an alkoxy group having 1 to 5 carbon atoms, or a halogen atom, and yet still more preferably a saturated chain hydrocarbon group having 1 to 10 carbon atoms or a halogen atom.

n1 to n8 are preferably each independently an integer of 0 to 2, and more preferably 0 or 1.

X⁹ to X¹² are preferably each independently -R⁵, - OR⁵, or a halogen atom, more preferably a saturated chain hydrocarbon group having 1 to 20 carbon atoms, an alkoxy group having 1 to 20 carbon atoms, or a halogen atom, still more preferably a saturated chain hydrocarbon group having 1 to 10 carbon atoms, an alkoxy group having 1 to 5 carbon atoms, or a halogen atom, and yet still more preferably a saturated chain hydrocarbon group having 1 to 10 carbon atoms, or a halogen atom.

n9 to n12 are preferably each independently an integer of 0 to 2, and more preferably 0 or 1.

R⁷ is preferably a hydrogen atom, a group represented by formula (ii), or a hydrocarbon group having 1 to 20 carbon atoms and optionally having a substituent, more preferably a hydrogen atom, a group represented by formula (ii), or an aromatic hydrocarbon group having 6 to 20 carbon atoms and optionally having a substituent, still more preferably a hydrogen atom, a group represented by formula (ii), or an aromatic hydrocarbon group having 6 to 10 carbon atoms and optionally having a substituent, and particularly preferably a hydrogen atom, a group represented by formula (ii), or a phenyl group optionally having a substituent.

In particular, when a1 is 0, R⁷ is preferably a hydrocarbon group having 1 to 20 carbon atoms and optionally having a substituent, more preferably an aromatic hydrocarbon group having 6 to 20 carbon atoms and optionally having a substituent, and still more preferably an aromatic hydrocarbon group having 6 to 10 carbon atoms and optionally having a substituent.

When a1 is 1, R⁷ is preferably a hydrogen atom, a group represented by formula (ii), or a hydrocarbon group having 1 to 20 carbon atoms and optionally having a substituent, more preferably a hydrogen atom, a group represented by formula (ii), or an aromatic hydrocarbon group having 6 to 20 carbon atoms and optionally having a substituent, and still more preferably a hydrogen atom, a group represented by formula (ii), or an aromatic hydrocarbon group having 6 to 10 carbon atoms and optionally having a substituent.

a1 is preferably 1.

R³ is preferably a group represented by *-R³¹-** or *-O-R³¹-O-**. R³¹ represents a hydrocarbon group optionally having a substituent, an aromatic heterocyclic group optionally having a substituent, or a group in which a hydrocarbon group optionally having a substituent and an aromatic heterocyclic group optionally having a substituent are combined, and -CH₂- contained in the hydrocarbon group is optionally replaced with -O-, -CO-, -NR⁶-, -S-, -SO-, or -SO₂-. However, -CH₂- at the end of a bond is not replaced with -O-, -CO-, -NR⁶-, S-, -SO-, or -SO₂-, and when R³¹ contains only an alkanediyl group, all (-CH₂-)s are not replaced with -O-, -CO-, -NR⁶-, -S-, -SO-, or -SO₂-. * represents a bond with a phosphorus atom to which Z¹ is bonded, and ** represents a bond with a phosphorus atom to which Z² is bonded.

The hydrocarbon group optionally having a substituent, the aromatic heterocyclic group optionally having a substituent, and the group in which a hydrocarbon group optionally having a substituent and an aromatic heterocyclic group optionally having a substituent are combined, which are represented by R³¹ are the same as the groups described as the hydrocarbon group optionally having a substituent, the aromatic heterocyclic group optionally having a substituent, and the group in which a hydrocarbon group optionally having a substituent and an aromatic heterocyclic group optionally having a substituent are combined, which are represented by R³.

R³¹ is
preferably a hydrocarbon group optionally having a substituent, or a group in which a hydrocarbon group optionally having a substituent and an aromatic heterocyclic group optionally having a substituent are combined,
more preferably a chain hydrocarbon group optionally having a substituent, an aromatic hydrocarbon group optionally having a substituent, a group in which a chain hydrocarbon group optionally having a substituent and an aromatic hydrocarbon group optionally having a substituent are combined, or a group in which a chain hydrocarbon group optionally having a substituent and an aromatic heterocyclic group optionally having a substituent are combined, and
still more preferably a chain hydrocarbon group optionally having a substituent, an aromatic hydrocarbon group optionally having a substituent, *-chain hydrocarbon group optionally having a substituent-aromatic hydrocarbon group optionally having a substituent-chain hydrocarbon group optionally having a substituent-*, *-aromatic hydrocarbon group optionally having a substituent-chain hydrocarbon group optionally having a substituent-aromatic hydrocarbon group optionally having a substituent-*, or *-chain hydrocarbon group optionally having a substituent-aromatic hydrocarbon group optionally having a substituent-chain hydrocarbon group optionally having a substituent-* (* represents a bond).

In the preferable aspect, the chain hydrocarbon group preferably has 1 to 10 carbon atoms, and more preferably 2 to 8 carbon atoms.

In the preferable aspect, the aromatic hydrocarbon group is preferably a phenylene group or a biphenylene group.

In the preferable aspect, -CH₂- contained in the hydrocarbon group (preferably the chain hydrocarbon group) is optionally replaced with -O-, -CO-, -NR⁶-, -S-, -SO-, or -SO₂-. However, -CH₂- at the end of a bond is not replaced with -O-, -CO-, -NR⁶-, S-, -SO-, or -SO₂-, and when R³¹ contains only an alkanediyl group, all (-CH₂-)s are not replaced with -O-, -CO-, -NR⁶-, -S-, -SO-, or -SO₂-.

Specifically, the chain hydrocarbon group represented by R³¹ is preferably a group represented by each of formula (1-1) to formula (1-23). In formula (1-1) to formula (1-23), R⁶ is the same as the above, and * represents a bond.

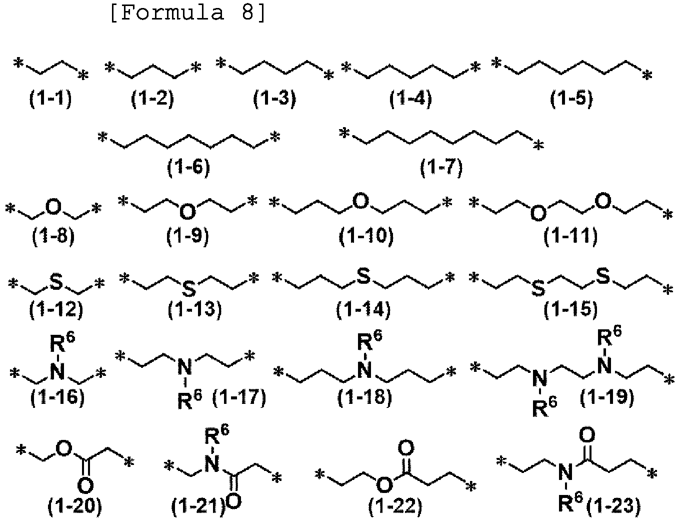

The aromatic hydrocarbon group in R³¹ is preferably a phenylene group or a biphenylene group, and more preferably a 1,3-phenylene group, a 1,4-phenylene group, or a biphenyl-4,4'-diyl group.

The *-chain hydrocarbon group optionally having a substituent-aromatic hydrocarbon group optionally having a substituent-chain hydrocarbon group optionally having a substituent-* in R³¹ is preferably a group represented by formula (2-1) or formula (2-2), and more preferably a group represented by formula (2-2).

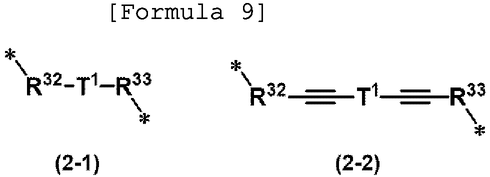

[In formula (2-1) and formula (2-2),
T¹ represents a phenylene group optionally having an alkyl group as a substituent, a biphenylene group optionally having an alkyl group as a substituent, or a fluorenediyl group optionally having an alkyl group as a substituent.
R³² and R³³ each independently represent an alkanediyl group having 1 to 10 carbon atoms.
* represents a bond.]

T¹ is preferably a phenylene group optionally having an alkyl group as a substituent, or a fluorenediyl group optionally having an alkyl group as a substituent from the viewpoint of further improving stability before and after post-baking.

The alkyl group as the substituent preferably has 1 to 8 carbon atoms, more preferably 1 to 4 carbon atoms, and is still more preferably a methyl group or an ethyl group. The number of the alkyl groups bonded to each of the phenylene group, the biphenylene group, and the fluorenediyl group is not particularly limited as long as it is a replaceable number, and preferably 1 to 4, and more preferably 1 or 2.

Examples of the alkanediyl group having 1 to 10 carbon atoms represented by R³² to R³³ include a group having 1 to 10 carbon atoms among the groups described as the straight-chain alkanediyl group and branched alkanediyl group. Among these, straight-chain alkanediyl having 1 to 10 carbon atoms is preferable, and straight-chain alkanediyl having 1 to 4 carbon atoms is more preferable.

R³² and R³³ are optionally the same or different, but are preferably the same.

Examples of the group represented by formula (2-1) include groups represented by formula (2-1-1) to formula (2-1-12), and examples of the group represented by formula (2-2) include groups represented by formula (2-2-1) to formula (2-2-16).

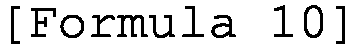

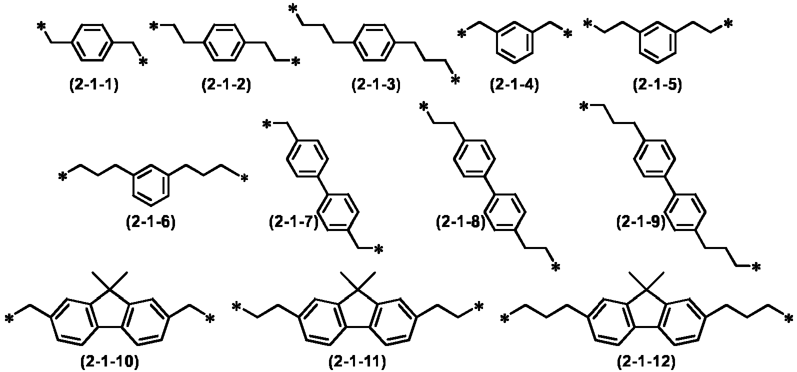

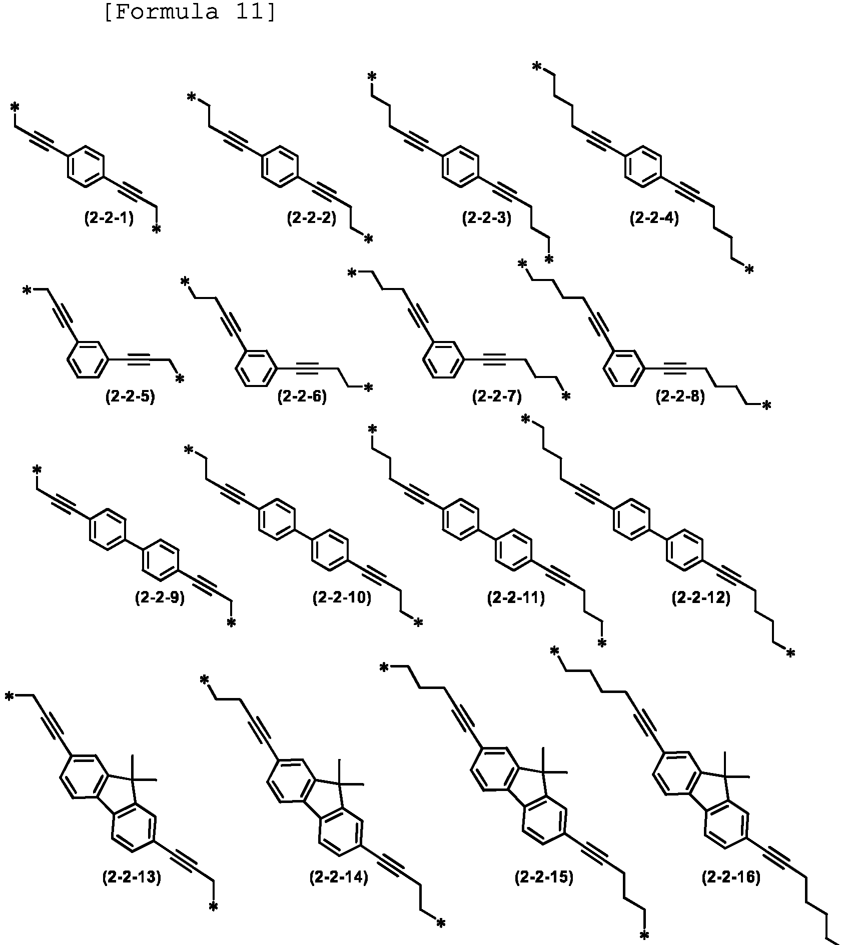

The *-aromatic hydrocarbon group optionally having a substituent-chain hydrocarbon group optionally having a substituent-aromatic hydrocarbon group optionally having a substituent-* in R³¹ is preferably a group represented by formula (3-1) or formula (3-2), and more preferably a group represented by formula (3-2).

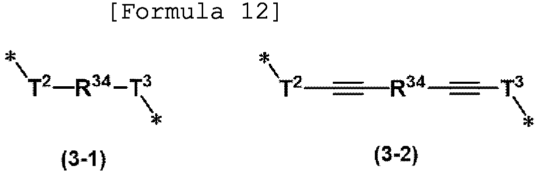

[In formula (3-1) and formula (3-2),
T² and T³ each independently represent a phenylene group optionally having an alkyl group as a substituent or a biphenylene group optionally having an alkyl group as a substituent.
R³⁴ represents an alkanediyl group having 1 to 10 carbon atoms.
* represents a bond.]

T² and T³ are preferably a phenylene group optionally having an alkyl group as a substituent.

The alkyl group as the substituent preferably has 1 to 8 carbon atoms, more preferably 1 to 4 carbon atoms, and is still more preferably a methyl group or an ethyl group. The number of the alkyl groups bonded to each of the phenylene group and the biphenylene group is not particularly limited as long as it is a replaceable number, and preferably 1 to 4, and more preferably 1 or 2.

Examples of the alkanediyl group having 1 to 10 carbon atoms represented by R³⁴ include a group having 1 to 10 carbon atoms among the groups described as the straight-chain alkanediyl group and branched alkanediyl group. Among these, straight-chain alkanediyl having 1 to 10 carbon atoms is preferable, and straight-chain alkanediyl having 1 to 4 carbon atoms is more preferable.

Examples of the group represented by formula (3-1) include groups represented by formula (3-1-1) to formula (3-1-9), and examples of the group represented by formula (3-2) include groups represented by (3-2-1) to formula (3-2-7).

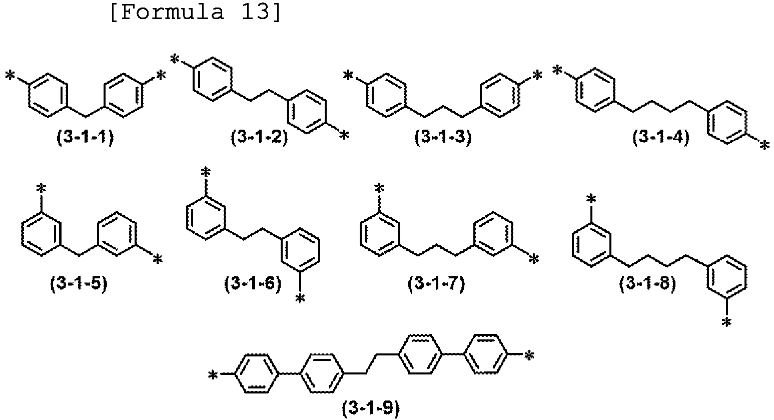

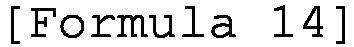

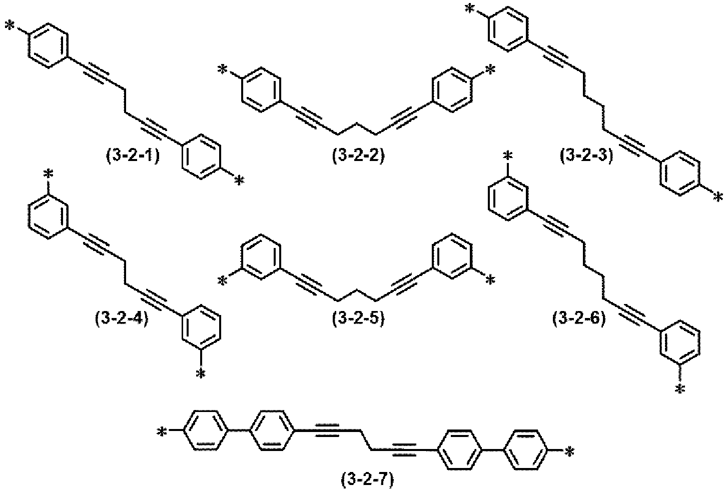

The *-chain hydrocarbon group optionally having a substituent-aromatic heterocyclic group optionally having a substituent-chain hydrocarbon group optionally having a substituent-* in R³¹ is preferably a group represented by formula (4-1) or formula (4-2), and more preferably a group represented by formula (4-2).

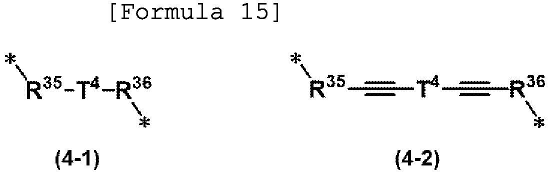

[In formula (4-1) and formula (4-2),
T⁴ represents a nitrogen-containing aromatic heterocycle.
R³⁵ and R³⁶ each independently represent an alkanediyl group having 1 to 10 carbon atoms.
* represents a bond.]

Examples of the alkanediyl group having 1 to 10 carbon atoms represented by R³⁵ to R³⁶ include a group having 1 to 10 carbon atoms among the groups described as the straight-chain alkanediyl group and branched alkanediyl group. Among these, straight-chain alkanediyl having 1 to 10 carbon atoms is preferable, and straight-chain alkanediyl having 1 to 4 carbon atoms is more preferable.

R³⁵ and R³⁶ are optionally the same or different, but are preferably the same.

The nitrogen-containing aromatic heterocycle represented by T⁴ is preferably a pyridine ring.

Examples of the group represented by formula (4-1) include groups represented by formula (4-1-1) to formula (4-1-3), and examples of the group represented by formula (4-2) include groups represented by formula (4-2-1) to formula (4-2-4).

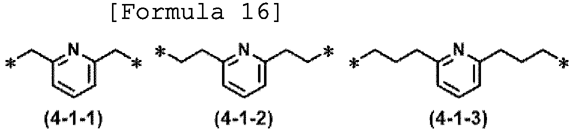

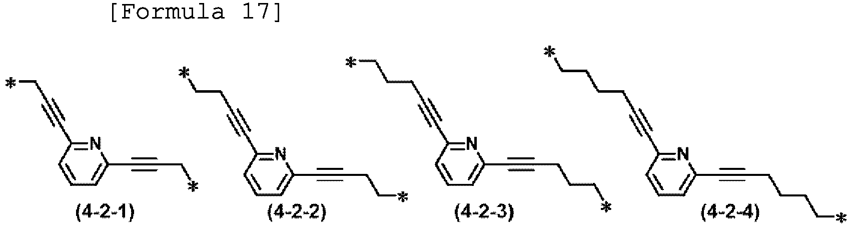

Among these, R³¹ in the groups represented by *-R³¹-** and *-O-R³¹-O-** is preferably a chain hydrocarbon group in which CH₂- is optionally replaced with -O-, - CO-, -NR⁶-, or -S-, an aromatic hydrocarbon group optionally having a substituent, or *-chain hydrocarbon group optionally having a substituent-aromatic hydrocarbon group optionally having a substituent-chain hydrocarbon group optionally having a substituent-*, more preferably groups represented by formula (1-1) to formula (1-23), a phenylene group optionally having a substituent, a biphenylene group optionally having a substituent, a group represented by formula (2-1), or a group represented by formula (2-2), and still more preferably groups represented by formula (1-1) to formula (1-23), a phenylene group optionally having a substituent, a group represented by formula (2-1), or a group represented by formula (2-2).

R⁶ is preferably a hydrogen atom.

Examples of the compound represented by formula (I) include compounds in which Z^{1A}, Z^{2A}, and R^{3A} are groups shown in the following Tables 1 to 5 in compounds represented by formula (I-a1) to formula (I-a3).

Hereinafter, in formula (I-a1), compounds having groups of Nos. 1 to 305 shown in Tables 1 to 5 are respectively referred to a compound (I-a1-1) to a compound (I-a1-305).

In formula (I-a2), compounds having groups of Nos. 1 to 305 shown in Tables 1 to 5 are respectively referred to a compound (I-a2-1) to a compound (I-a2-305).

In formula (I-a3), compounds having groups of Nos. 1 to 305 shown in Tables 1 to 5 are respectively referred to a compound (I-a3-1) to a compound (I-a3-305).

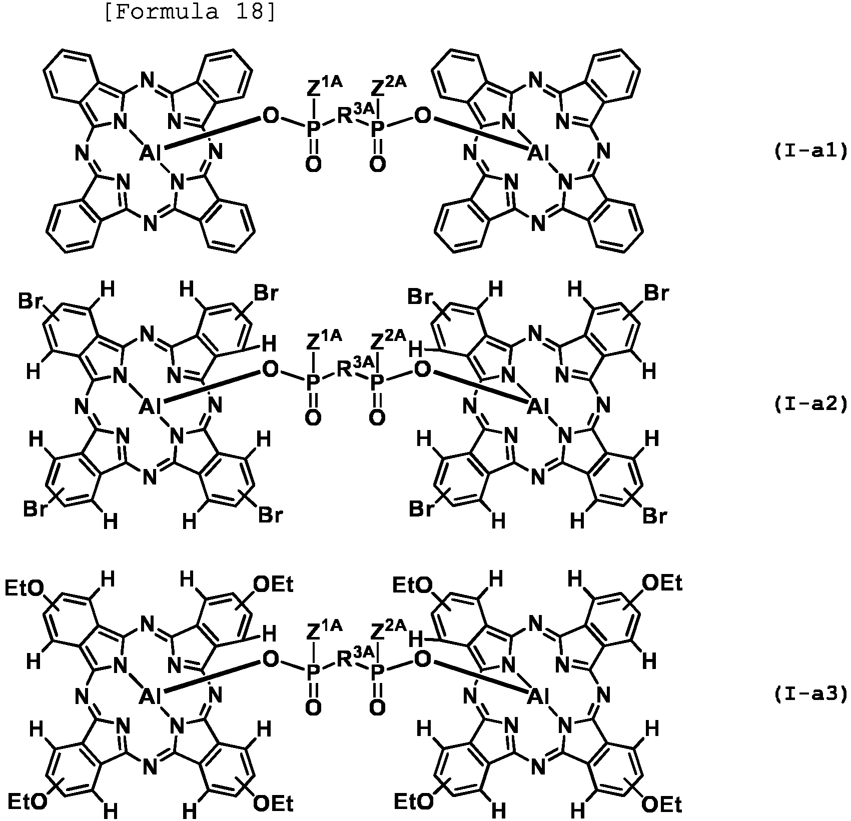

**[Table 1]**

| No. | Z^{1A} | Z^{2A} | R^{3A} |
|---|---|---|---|
| 1 | z1 | z1 | r1 |
| 2 | z1 | z1 | r2 |
| 3 | z1 | z1 | r3 |
| 4 | z1 | z1 | r4 |
| 5 | z1 | z1 | r5 |
| 6 | z1 | z1 | r6 |
| 7 | z1 | z1 | r7 |
| 8 | z1 | z1 | r8 |
| 9 | z1 | z1 | r9 |
| 10 | z1 | z1 | r10 |
| 11 | z1 | z1 | r11 |
| 12 | z1 | z1 | r12 |
| 13 | z1 | z1 | r13 |
| 14 | z1 | z1 | r14 |
| 15 | z1 | z1 | r15 |
| 16 | z1 | z1 | r16 |
| 17 | z2 | z2 | r1 |
| 18 | z2 | z2 | r2 |
| 19 | z2 | z2 | r3 |
| 20 | z2 | z2 | r4 |
| 21 | z2 | z2 | r5 |
| 22 | z2 | z2 | r6 |
| 23 | z2 | z2 | r7 |
| 24 | z2 | z2 | r8 |
| 25 | z2 | z2 | r9 |
| 26 | z2 | z2 | r10 |
| 27 | z2 | z2 | r11 |
| 28 | z2 | z2 | r12 |
| 29 | z2 | z2 | r13 |
| 30 | z2 | z2 | r14 |
| 31 | z2 | z2 | r15 |
| 32 | z2 | z2 | r16 |
| 33 | z3 | z3 | r1 |
| 34 | z3 | z3 | r2 |
| 35 | z3 | z3 | r3 |
| 36 | z3 | z3 | r4 |
| 37 | z3 | z3 | r5 |
| 38 | z3 | z3 | r6 |
| 39 | z3 | z3 | r7 |
| 40 | z3 | z3 | r8 |
| 41 | z3 | z3 | r9 |
| 42 | z3 | z3 | r10 |
| 43 | z3 | z3 | r11 |
| 44 | z3 | z3 | r12 |
| 45 | z3 | z3 | r13 |
| 46 | z3 | z3 | r14 |
| 47 | z3 | z3 | r15 |
| 48 | z3 | z3 | r16 |
| 49 | z4 | z4 | r1 |
| 50 | z4 | z4 | r2 |
| 51 | z4 | z4 | r3 |
| 52 | z4 | z4 | r4 |
| 53 | z4 | z4 | r5 |
| 54 | z4 | z4 | r6 |
| 55 | z4 | z4 | r7 |
| 56 | z4 | z4 | r8 |
| 57 | z4 | z4 | r9 |
| 58 | z4 | z4 | r10 |
| 59 | z4 | z4 | r11 |
| 60 | z4 | z4 | r12 |
| 61 | z4 | z4 | r13 |
| 62 | z4 | z4 | r14 |
| 63 | z4 | z4 | r15 |
| 64 | z4 | z4 | r16 |
| 65 | z1 | z2 | r1 |
| 66 | z1 | z2 | r2 |
| 67 | z1 | z2 | r3 |
| 68 | z1 | z2 | r4 |
| 69 | z1 | z2 | r5 |
| 70 | z1 | z2 | r6 |
| 71 | z1 | z2 | r7 |
| 72 | z1 | z2 | r8 |
| 73 | z1 | z2 | r9 |
| 74 | z1 | z2 | r10 |
| 75 | z1 | z2 | r11 |
| 76 | z1 | z2 | r12 |
| 77 | z1 | z2 | r13 |
| 78 | z1 | z2 | r14 |
| 79 | z1 | z2 | r15 |
| 80 | z1 | z2 | r16 |

**[Table 2]**

| No. | Z^{1A} | Z^{2A} | R^{3A} |
|---|---|---|---|
| 81 | z1 | z3 | r1 |
| 82 | z1 | z3 | r2 |
| 83 | z1 | z3 | r3 |
| 84 | z1 | z3 | r4 |
| 85 | z1 | z3 | r5 |
| 86 | z1 | z3 | r6 |
| 87 | z1 | z3 | r7 |
| 88 | z1 | z3 | r8 |
| 89 | z1 | z3 | r9 |
| 90 | z1 | z3 | r10 |
| 91 | z1 | z3 | r11 |
| 92 | z1 | z3 | r12 |
| 93 | z1 | z3 | r13 |
| 94 | z1 | z3 | r14 |
| 95 | z1 | z3 | r15 |
| 96 | z1 | z3 | r16 |
| 97 | z1 | z4 | r1 |
| 98 | z1 | z4 | r2 |
| 99 | z1 | z4 | r3 |
| 100 | z1 | z4 | r4 |
| 101 | z1 | z4 | r5 |
| 102 | z1 | z4 | r6 |
| 103 | z1 | z4 | r7 |
| 104 | z1 | z4 | r8 |
| 105 | z1 | z4 | r9 |
| 106 | z1 | z4 | r10 |
| 107 | z1 | z4 | r11 |
| 108 | z1 | z4 | r12 |
| 109 | z1 | z4 | r13 |
| 110 | z1 | z4 | r14 |
| 111 | z1 | z4 | r15 |
| 112 | z1 | z4 | r16 |
| 113 | z2 | z1 | r6 |
| 114 | z2 | z1 | r7 |
| 115 | z2 | z3 | r1 |
| 116 | z2 | z3 | r2 |
| 117 | z2 | z3 | r3 |
| 118 | z2 | z3 | r4 |
| 119 | z2 | z3 | r5 |
| 120 | z2 | z3 | r6 |
| 121 | z2 | z3 | r7 |
| 122 | z2 | z3 | r8 |
| 123 | z2 | z3 | r9 |
| 124 | z2 | z3 | r10 |
| 125 | z2 | z3 | r11 |
| 126 | z2 | z3 | r12 |
| 127 | z2 | z3 | r13 |
| 128 | z2 | z3 | r14 |
| 129 | z2 | z3 | r15 |
| 130 | z2 | z3 | r16 |
| 131 | z2 | z4 | r1 |
| 132 | z2 | z4 | r2 |
| 133 | z2 | z4 | r3 |
| 134 | z2 | z4 | r4 |
| 135 | z2 | z4 | r5 |
| 136 | z2 | z4 | r6 |
| 137 | z2 | z4 | r7 |
| 138 | z2 | z4 | r8 |
| 139 | z2 | z4 | r9 |
| 140 | z2 | z4 | r10 |
| 141 | z2 | z4 | r11 |
| 142 | z2 | z4 | r12 |
| 143 | z2 | z4 | r13 |
| 144 | z2 | z4 | r14 |
| 145 | z2 | z4 | r15 |
| 146 | z2 | z4 | r16 |
| 147 | z3 | z1 | r6 |
| 148 | z3 | z1 | r7 |
| 149 | z3 | z2 | r6 |
| 150 | z3 | z2 | r7 |
| 151 | z3 | z4 | r1 |
| 152 | z3 | z4 | r2 |
| 153 | z3 | z4 | r3 |
| 154 | z3 | z4 | r4 |
| 155 | z3 | z4 | r5 |
| 156 | z3 | z4 | r6 |
| 157 | z3 | z4 | r7 |
| 158 | z3 | z4 | r8 |
| 159 | z3 | z4 | r9 |
| 160 | z3 | z4 | r10 |

**[Table 3]**

| No. | Z^{1A} | Z^{2A} | R^{3A} |
|---|---|---|---|
| 161 | z3 | z4 | r11 |
| 162 | z3 | z4 | r12 |
| 163 | z3 | z4 | r13 |
| 164 | z3 | z4 | r14 |
| 165 | z3 | z4 | r15 |
| 166 | z3 | z4 | r16 |
| 167 | z4 | z1 | r6 |
| 168 | z4 | z1 | r7 |
| 169 | z4 | z2 | r6 |
| 170 | z4 | z2 | r7 |
| 171 | z4 | z3 | r6 |
| 172 | z4 | z3 | r7 |

**[Table 4]**

| No. | Z^{1A} | Z^{2A} | R^{3A} |
|---|---|---|---|
| 173 | z1 | z1 | r17 |
| 174 | z1 | z1 | r18 |
| 175 | z1 | z1 | r19 |
| 176 | z2 | z2 | r17 |
| 177 | z2 | z2 | r18 |
| 178 | z2 | z2 | r19 |
| 179 | z3 | z3 | r17 |
| 180 | z3 | z3 | r18 |
| 181 | z3 | z3 | r19 |
| 182 | z4 | z4 | r17 |
| 183 | z4 | z4 | r18 |
| 184 | z4 | z4 | r19 |
| 185 | z5 | z5 | r1 |
| 186 | z5 | z5 | r2 |
| 187 | z5 | z5 | r3 |
| 188 | z5 | z5 | r4 |
| 189 | z5 | z5 | r5 |
| 190 | z5 | z5 | r6 |
| 191 | z5 | z5 | r7 |
| 192 | z5 | z5 | r8 |
| 193 | z5 | z5 | r9 |
| 194 | z5 | z5 | r10 |
| 195 | z5 | z5 | r11 |
| 196 | z5 | z5 | r12 |
| 197 | z5 | z5 | r13 |
| 198 | z5 | z5 | r14 |
| 199 | z5 | z5 | r15 |
| 200 | z5 | z5 | r16 |
| 201 | z5 | z5 | r17 |
| 202 | z5 | z5 | r18 |
| 203 | z5 | z5 | r19 |
| 204 | z1 | z2 | r17 |
| 205 | z1 | z2 | r18 |
| 206 | z1 | z2 | r19 |
| 207 | z1 | z3 | r17 |
| 208 | z1 | z3 | r18 |
| 209 | z1 | z3 | r19 |
| 210 | z1 | z4 | r17 |
| 211 | z1 | z4 | r18 |
| 212 | z1 | z4 | r19 |
| 213 | z1 | z5 | r1 |
| 214 | z1 | z5 | r2 |
| 215 | z1 | z5 | r3 |
| 216 | z1 | z5 | r4 |
| 217 | z1 | z5 | r5 |
| 218 | z1 | z5 | r6 |
| 219 | z1 | z5 | r7 |
| 220 | z1 | z5 | r8 |
| 221 | z1 | z5 | r9 |
| 222 | z1 | z5 | r10 |
| 223 | z1 | z5 | r11 |
| 224 | z1 | z5 | r12 |
| 225 | z1 | z5 | r13 |
| 226 | z1 | z5 | r14 |
| 227 | z1 | z5 | r15 |
| 228 | z1 | z5 | r16 |
| 229 | z1 | z5 | r17 |
| 230 | z1 | z5 | r18 |
| 231 | z1 | z5 | r19 |
| 232 | z2 | z3 | r17 |
| 233 | z2 | z3 | r18 |
| 234 | z2 | z3 | r19 |
| 235 | z2 | z4 | r17 |
| 236 | z2 | z4 | r18 |
| 237 | z2 | z4 | r19 |
| 238 | z2 | z5 | r1 |
| 239 | z2 | z5 | r2 |
| 240 | z2 | z5 | r3 |
| 241 | z2 | z5 | r4 |
| 242 | z2 | z5 | r5 |
| 243 | z2 | z5 | r6 |
| 244 | z2 | z5 | r7 |
| 245 | z2 | z5 | r8 |
| 246 | z2 | z5 | r9 |
| 247 | z2 | z5 | r10 |
| 248 | z2 | z5 | r11 |
| 249 | z2 | z5 | r12 |
| 250 | z2 | z5 | r13 |
| 251 | z2 | z5 | r14 |
| 252 | z2 | z5 | r15 |
| 253 | z2 | z5 | r16 |
| 254 | z2 | z5 | r17 |
| 255 | z2 | z5 | r18 |
| 256 | z2 | z5 | r19 |
| 257 | z3 | z4 | r17 |
| 258 | z3 | z4 | r18 |
| 259 | z3 | z4 | r19 |
| 260 | z3 | z5 | r1 |
| 261 | z3 | z5 | r2 |
| 262 | z3 | z5 | r3 |
| 263 | z3 | z5 | r4 |
| 264 | z3 | z5 | r5 |
| 265 | z3 | z5 | r6 |
| 266 | z3 | z5 | r7 |
| 267 | z3 | z5 | r8 |
| 268 | z3 | z5 | r9 |

**[Table 5]**

| No. | Z^{1A} | Z^{2A} | R^{3A} |
|---|---|---|---|
| 269 | z3 | z5 | r10 |
| 270 | z3 | z5 | r11 |
| 271 | z3 | z5 | r12 |
| 272 | z3 | z5 | r13 |
| 273 | z3 | z5 | r14 |
| 274 | z3 | z5 | r15 |
| 275 | z3 | z5 | r16 |
| 276 | z3 | z5 | r17 |
| 277 | z3 | z5 | r18 |
| 278 | z3 | z5 | r19 |
| 279 | z4 | z5 | r1 |
| 280 | z4 | z5 | r2 |
| 281 | z4 | z5 | r3 |
| 282 | z4 | z5 | r4 |
| 283 | z4 | z5 | r5 |
| 284 | z4 | z5 | r6 |
| 285 | z4 | z5 | r7 |
| 286 | z4 | z5 | r8 |
| 287 | z4 | z5 | r9 |
| 288 | z4 | z5 | r10 |
| 289 | z4 | z5 | r11 |
| 290 | z4 | z5 | r12 |
| 291 | z4 | z5 | r13 |
| 292 | z4 | z5 | r14 |
| 293 | z4 | z5 | r15 |
| 294 | z4 | z5 | r16 |
| 295 | z4 | z5 | r17 |
| 296 | z4 | z5 | r18 |
| 297 | z4 | z5 | r19 |
| 298 | z5 | r1 | r6 |
| 299 | z5 | r1 | r7 |
| 300 | z5 | r2 | r6 |
| 301 | z5 | r2 | r7 |
| 302 | z5 | r3 | r6 |
| 303 | z5 | r3 | r7 |
| 304 | z5 | r4 | r6 |
| 305 | z5 | r4 | r7 |

In Tables 1 to 5, z1 to z5 respectively correspond to groups represented by the following formulas (zl) to (z5), and r1 to r19 respectively correspond to groups represented by the following formulas (r1) to (r19).

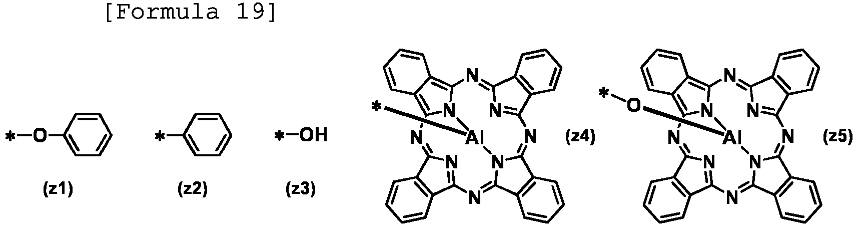

[In formula (Zl) to formula (Z5), * represents a bond with a phosphorus atom.]

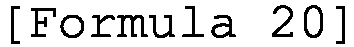

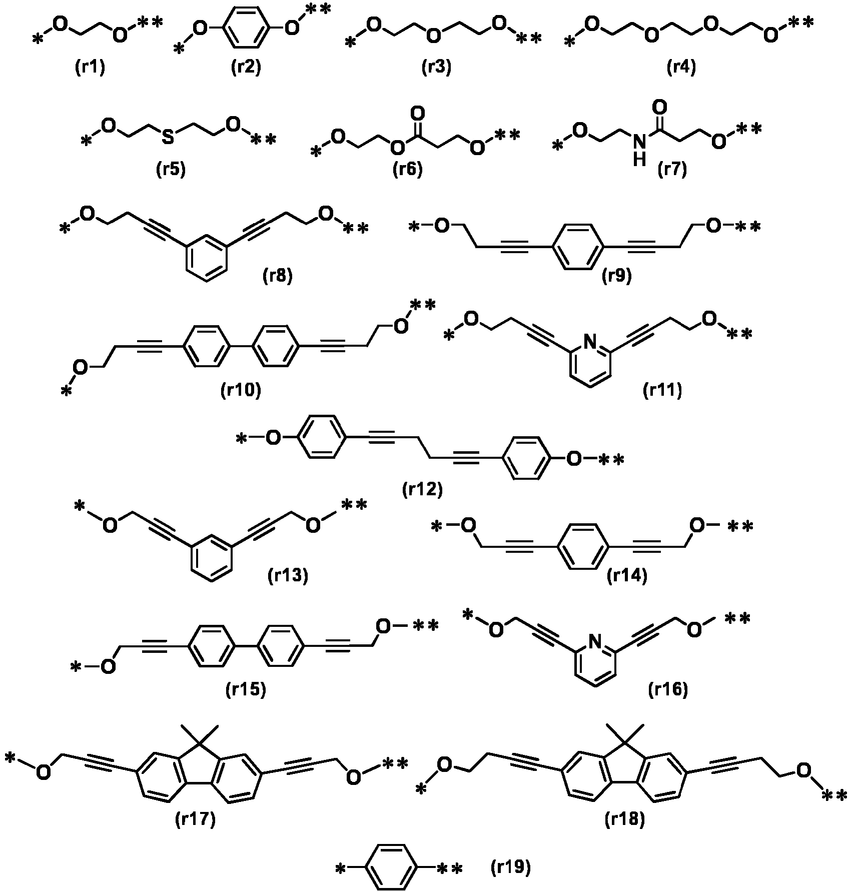

[In formula (r1) to formula (rl9), * represents a bond with a phosphorus atom to which Z^{1A} is bonded, and ** represents a bond with a phosphorus atom to which Z^{2A} is bonded.]

The compound represented by formula (I) is preferably compounds (I-a1-1) to (I-al-48), compounds (I-a1-173) to (I-a1-181), compounds (I-a1-185) to (I-al-203), compounds (I-al-260) to (I-al-278), compounds (I-al-302) to (I-al-303), compounds (I-a2-1) to (I-a2-48), compounds (I-a2-173) to (I-a2-181), compounds (I-a3-1) to (I-a3-48), and compounds (I-a3-173) to (I-a3-181), and more preferably compounds (I-a1-1) to (I-a1-16), compounds (I-a1-173) to (I-a1-175), a compound (I-al-181), a compound (I-al-203), a compound (I-al-278), compounds (I-a2-1) to (I-a2-16), compounds (I-a2-173) to (I-a2-175), a compound (I-a2-181), compounds (I-a3-1) to (I-a3-16), compounds (I-a3-173) to (I-a3-175), and a compound (I-a3-181).

Examples of a method for producing the compound represented by formula (I) include the following methods (i) to (iv). The following methods (i) to (iv) are only examples of the production process of the compound represented by formula (I), and the compound can also be produced by appropriately combined known reactions.

### [Method (i)]

A compound (I') in which R³ is a group represented by *-O-R³¹-O-**, as an objective compound is obtained by, for example, appropriately reacting a compound represented by formula (II-1), a compound represented by formula (II-2), and a compound represented by formula (II-3) to synthesize a compound represented by formula (III), then converting a halogen atom Xⁱ of the compound represented by formula (III) into a hydroxyl group to synthesize a compound represented by formula (IV), and thereafter appropriately reacting the compound represented by formula (IV), a compound represented by formula (V-1), and a compound represented by formula (V-2) .

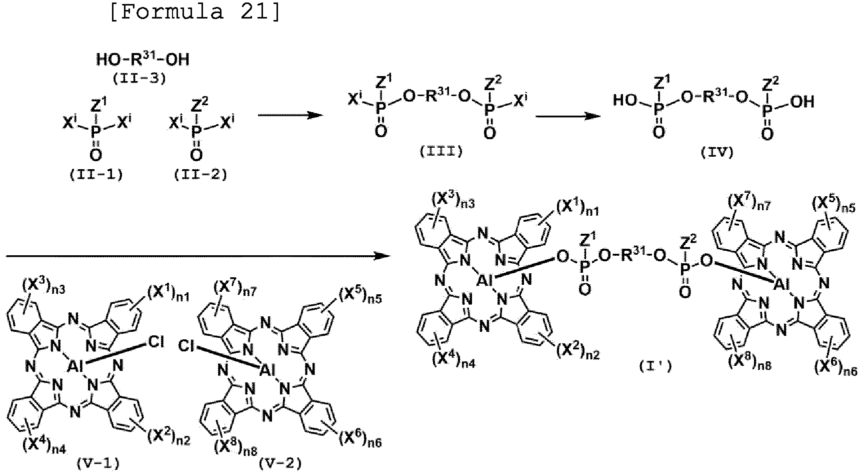

In the formula, Xⁱ represents a halogen atom, and X¹ to X⁸, nl to n8, Z¹ to Z², and R³¹ have the same meaning as above.

A plurality of (Xⁱ)s are optionally the same or different. Xⁱ is preferably a chlorine atom.

### [Method (ii)]

In the case of a compound (I'') in which R³ is a group represented by *-O-R³¹-O-**, and R³¹ is a group represented by the formula (2-2), for example, the compound represented by formula (II-1), the compound represented by formula (VI-1), the compound represented by formula (II-2), and the compound represented by formula (VI-2) are appropriately reacted to synthesize compounds represented by formula (VII-1) and formula (VII-2). Then, compounds represented by formula (VIII-1) and formula (VIII-2) are synthesized by converting a halogen atom Xⁱ of the compounds represented by formula (VII-1) and formula (VII-2) into a hydroxyl group. A compound represented by formula (X) can be synthesized by a Sonogashira coupling reaction using the obtained compounds represented by formula (VIII-1) and formula (VIII-2), and a compound represented by formula (IX), and an objective compound can be obtained by appropriately reacting the compound represented by formula (X), the compound represented by formula (V-1), and the compound represented by formula (V-2).

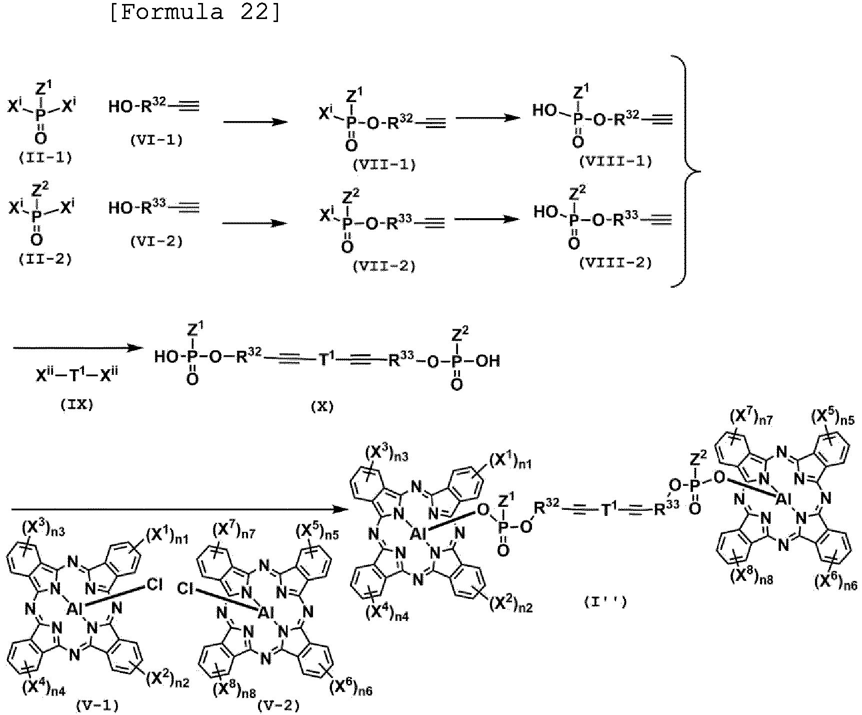

In the formula, Xⁱⁱ represents a halogen atom, and Xⁱ, X¹ to X⁸, n1 to n8, Z¹ to Z², T¹, and R³² to R³³ have the same meaning as the above.

A plurality of (Xⁱⁱ)s are optionally the same or different. Xⁱⁱ is preferably an iodine atom.

### [Method (iii)]

In the case of a compound (I‴) in which R³ is a group represented by *-O-R³¹-O-**, and R³¹ is a group represented by the formula (3-2), for example, a compound represented by formula (II-1), a compound represented by formula (XI-1), a compound represented by formula (II-2), and a compound represented by formula (XI-2) are reacted to synthesize a compound represented by formula (XII-1) and a compound represented by formula (XII-2). Then, compounds represented by formula (XIII-1) and formula (XIII-2) are synthesized by converting a halogen atom Xⁱ of the compounds represented by formula (XII-1) and formula (XII-2) into a hydroxyl group. A compound represented by formula (XV) can be synthesized by a Sonogashira coupling reaction using the obtained compounds represented by formula (XIII-1) and formula (XIII-2), and the compound represented by formula (XIV), and an objective compound can be obtained by appropriately reacting the compound represented by formula (XV), the compound represented by formula (V-1), and the compound represented by formula (V-2).

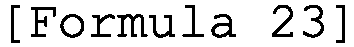

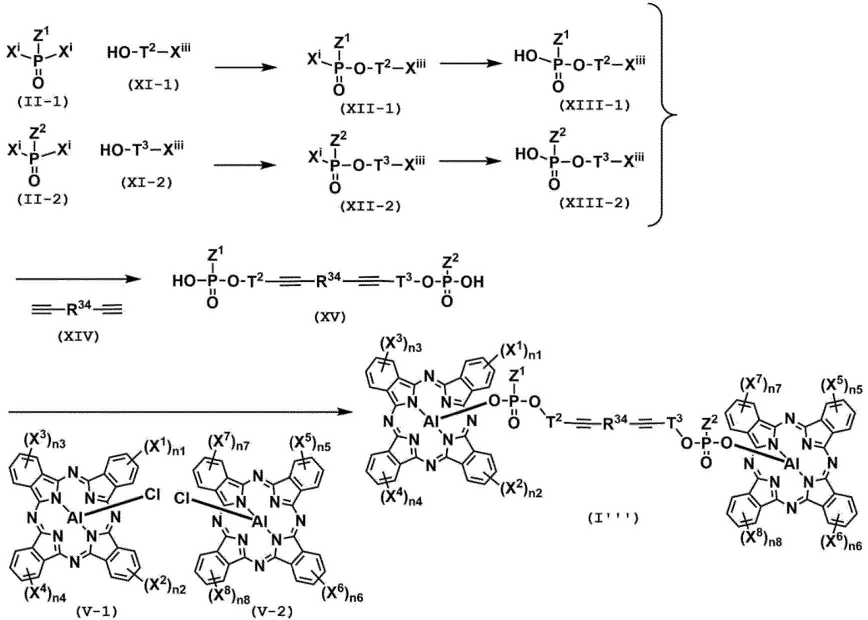

In the formula, Xⁱⁱⁱ represents a halogen atom, and Xⁱ, X¹ to X⁸, and nl to n8, Z¹ to Z², T² to T³, and R³⁴ have the same meaning as above.

Xⁱⁱⁱ is preferably an iodine atom.

### [Method (iv)]

A compound (Iʺʺ) in which R³ is a group represented by *-R³¹-** is obtained by, for example, appropriately reacting a compound represented by formula (XVI), a compound represented by formula (V-1), and a compound represented by formula (V-2).

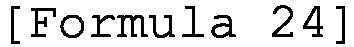

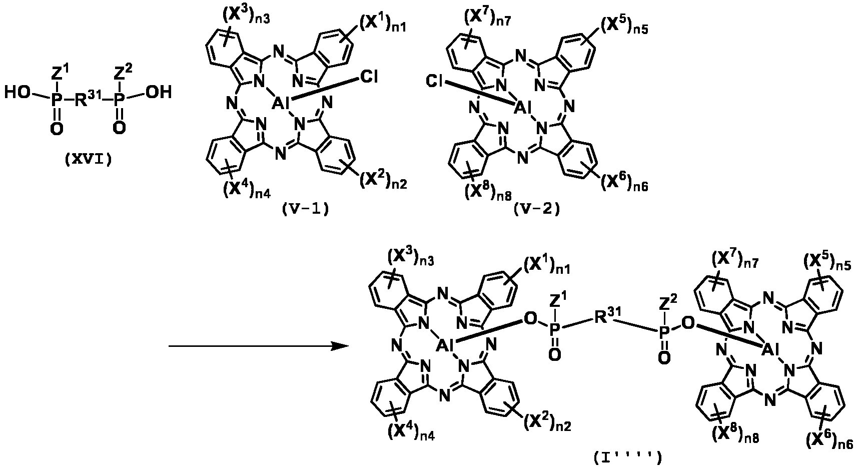

In the formula, X¹ to X⁸, nl to n8, Z¹ to Z², and R³¹ have the same meaning as the above.

### <<Colored Resin Composition>>

The present invention contains the compound represented by formula (I) described above (hereafter, sometimes referred to as compound (I)) and a colored resin composition containing a resin (hereinafter, sometimes referred to as resin (B)). The colored resin composition of the present invention preferably contains the compound (I) described above as a colorant (hereinafter, sometimes referred to as colorant (A)).

The colored resin composition of the present invention preferably further contains a polymerizable compound (hereinafter, sometimes referred to as polymerizable compound (C)) and a polymerization initiator (hereinafter, sometimes referred to as polymerization initiator (D)).

The colored resin composition of the present invention preferably further contains a solvent (hereinafter, sometimes referred to as solvent (E)).

The colored resin composition of the present invention optionally contains a leveling agent (hereinafter, sometimes referred to as leveling agent (F)).

Herein, compounds exemplified as components may be used singly or in combinations of a plurality thereof unless otherwise noted.

### <Colorant (A)>

The colored resin composition of the present invention contains the compound (I) as the colorant (A). The content rate of the compound (I) is preferably 0.5 to 70% by mass, more preferably 1 to 55% by mass, still more preferably 2 to 50% by mass, and particularly preferably 5 to 40% by mass or 8 to 40% by mass in the whole amount of the solid content of the colored resin composition.

Herein, the term "whole amount of solid content" means the total amount of components obtained by excluding the solvent from the colored resin composition of the present invention. The whole amount of the solid content and the content of each of the components with respect thereto can be measured by known analysis means such as liquid chromatography or gas chromatography.

The content rate of the compound (I) is preferably 20 to 100% by mass, more preferably 30 to 100% by mass, and still more preferably 40 to 100% by mass in the whole amount of the colorant (A). The content rate of the compound (I) is optionally 60% by mass or more, 80% by mass or more, or 90% by mass or more in the whole amount of the colorant (A).

The colorant (A) optionally further contains a different colorant from the compound (I) (hereinafter, sometimes referred to as colorant (A2)).

The colorant (A2) may be any of a dye and a pigment.

Examples of the dye include a compound which is not a pigment but classified into a compound having a hue in the Color Index (published by The Society of Dyers and Colourists), and a known dye as described in Dyeing note (Shikisensha Co., Ltd.). Particularly preferred is a xanthene dye.

The xanthene dye is a dye containing a compound having a xanthene skeleton in its molecule. Specific examples of the xanthene dye include C. I. Acid Red 51 (hereinafter, the description of C. I. Acid Red is omitted and only the number is described, and the same is true on other dyes), 52, 87, 92, 94, 289, or 388; C. I. Acid Violet 9, 30, or 102; C. I. Basic Red 1 (Rhodamine 6G), 2, 3, 4, 8, 10, or 11; C. I. Basic Violet 10 (Rhodamine B) or 11; C. I. Solvent Red 218; C. I. Mordant Red 27; C. I. Reactive Red 36 (Rose Bengal B); Sulforhodamine G; a xanthene dye described in Japanese Patent Laid-Open No. 2010-32999; and a xanthene dye described in Japanese Patent No. 4492760. The xanthene dye is preferably dissolved in an organic solvent.

The xanthene dye which can be used is any commercially available xanthene dye (for example, "Chugai Aminol Fast Pink R-H/C" manufactured by Chugai Kasei Co., Ltd., or "Rhodamin 6G" manufactured by Taoka Chemical Co., Ltd.). The xanthene dye can also be synthesized with a commercially available xanthene dye as a starting material, with reference to Japanese Patent Laid-Open No. 2010-32999.

As the other dye, an azo dye, a cyanine dye, a triphenylmethane dye, a thiazole dye, an oxazine dye, a phthalocyanine dye, a quinophtharone dye, an anthraquinone dye, a naphthoquinone dye, a quinonimine dye, a methine dye, an azomethine dye, a squarylium dye, an acridine dye, a styryl dye, a coumarin dye, a quinoline dye, and a nitro dye and the like may be used, and for each of these dyes, known dyes are used.

Specific examples of such a dye include
C. I. Solvent dyes such as:
   C. I. Solvent Yellows 4 (hereinafter, the term "C. I. Solvent Yellow" is omitted and only the number is described, and the same is true on other dyes), 14, 15, 23, 24, 38, 62, 63, 68, 82, 94, 98, 99, 117, 162, 163, 167, and 189;
   C. I. Solvent Reds 45, 49, 111, 125, 130, 143, 145, 146, 150, 151, 155, 168, 169, 172, 175, 181, 207, 222, 227, 230, 245, 247;
   C. I. Solvent Oranges 2, 7, 11, 15, 26, 56, 77, and 86;
   C. I. Solvent Violets 11, 13, 14, 26, 31, 36, 37, 38, 45, 47, 48, 51, 59, and 60;
   C. I. Solvent Blues 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136, 139;
   C. I. Solvent Greens 1, 3, 4, 5, 7, 28, 29, 32, 33, 34, and 35,
C. I. Acid dyes such as:
   C. I. Acid Yellows 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, 251;
   C. I. Acid Reds 1, 4, 8, 14, 17, 18, 26, 27, 29, 31, 33, 34, 35, 37, 40, 42, 44, 50, 57, 66, 73, 76, 80, 88, 91, 95, 97, 98, 103, 106, 111, 114, 129, 133, 134, 138, 143, 145, 150, 151, 155, 158, 160, 172, 176, 182, 183, 195, 198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422, 426;
   C. I. Acid Oranges 6, 7, 8, 10, 12, 26, 50, 51, 52, 56, 62, 63, 64, 74, 75, 94, 95, 107, 108, 169, and 173;
   C. I. Acid Violets 6B, 7, 15, 16, 17, 19, 21, 23, 24, 25, 34, 38, 49, 72;
   C. I. acid blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335, 340;
   C. I. Acid Greens 1, 3, 5, 6, 7, 8, 9, 11, 13, 14, 15, 16, 22, 25, 27, 28, 41, 50, 50:1, 58, 63, 65, 80, 104, 105, 106, and 109,
C. I. Direct dyes such as:
   C. I. Direct Yellows 2, 33, 34, 35, 38, 39, 43, 47, 50, 54, 58, 68, 69, 70, 71, 86, 93, 94, 95, 98, 102, 108, 109, 129, 136, 138, 141;
   C. I. Direct Reds 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, 250;
   C. I. Direct Oranges 26, 34, 39, 41, 46, 50, 52, 56, 57, 61, 64, 65, 68, 70, 96, 97, 106, and 107;
   C. I. Direct Violets 47, 52, 54, 59, 60, 65, 66, 79, 80, 81, 82, 84, 89, 90, 93, 95, 96, 103, and 104;
   C. I. Direct Blues 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, 293;
   C. I. Direct Greens 25, 27, 31, 32, 34, 37, 63, 65, 66, 67, 68, 69, 72, 77, 79, and 82,
C. I. Disperse dyes such as:
   C. I. Disperse Yellows 51, 54, and 76;
   C. I. Disperse Violets 26 and 27;
   C. I. Disperse Blues 1, 14, 56, and 60,
C. I. Basic dyes such as:
   C. I. Basic Blues 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
   C. I. Basic Violet 2;
   C. I. Basic Red 9;
   C. I. Basic Green 1;
C. I. Reactive dyes such as:
   C. I. Reactive Yellows 2, 76, and 116;
   C. I. Reactive Orange 16;
   C. I. Reactive Red 36;
C. I. Mordant dyes such as:
   C. I. Mordant Yellows 5, 8, 10, 16, 20, 26, 30, 31, 33, 42, 43, 45, 56, 61, 62, and 65;
   C. I. Mordant Reds 1, 2, 3, 4, 9, 11, 12, 14, 17, 18, 19, 22, 23, 24, 25, 26, 29, 30, 32, 33, 36, 37, 38, 39, 41, 42, 43, 45, 46, 48, 52, 53, 56, 62, 63, 71, 74, 76, 78, 85, 86, 88, 90, 94, 95;
   C. I. Mordant Oranges 3, 4, 5, 8, 12, 13, 14, 20, 21, 23, 24, 28, 29, 32, 34, 35, 36, 37, 42, 43, 47, and 48;
   C. I. Mordant Violets 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, 58;
   C. I. Mordant Blues 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, 84;
   C. I. Mordant Greens 1, 3, 4, 5, 10, 13, 15, 19, 21, 23, 26, 29, 31, 33, 34, 35, 41, 43, and 53; and
C. I. Vat dyes such as:
   C. I. Vat Green 1.

One dye or a plurality of dyes are optionally used for each of the colors of these dyes, and the dyes of the colors are optionally used in combination.

Examples of the pigment include a pigment which is classified into a pigment in the Color Index (published by The Society of Dyers and Colourists), and the following pigments can be exemplified:
green pigments: C. I. Pigment Greens 7, 36, and 58 and the like;
yellow pigments: C. I. Pigment Yellows 1, 3, 12, 13, 14, 15, 16, 17, 20, 24, 31, 53, 83, 86, 93, 94, 109, 110, 117, 125, 128, 129, 137, 138, 139, 147, 148, 150, 153, 154, 166, 173, 185, 194, and 214 and the like;
orange pigments: C. I. Pigment Oranges 13, 31, 36, 38, 40, 42, 43, 51, 55, 59, 61, 64, 65, 71, and 73 and the like;
red pigments: C. I. Pigment Reds 9, 97, 105, 122, 123, 144, 149, 166, 168, 176, 177, 180, 192, 209, 215, 216, 224, 242, 254, 255, 264, and 265 and the like;
blue pigments: C. I. Pigment Blues 15, 15:3, 15:4, 15:6, and 60 and the like; and
violet pigments: C. I. Pigment Violets 1, 19, 23, 29, 32, 36, and 38 and the like.

One pigment or a plurality of pigments may be used for each of the colors of these pigments, and the pigments of the colors may be combined.

Among these, a yellow pigment and/or a blue pigment are preferable, and at least one kind selected from the group consisting of C. I. Pigment Yellow 150, C. I. Pigment Yellow 185, C. I. Pigment Blue 15:3, C. I. Pigment Blue 15:4, and C. I. Pigment Blue 15:6 is preferable. When the colored resin composition according to the present invention does not contain any pigments other than the compound represented by formula (I), or contains any pigments other than the compound represented by formula (I) from the viewpoint of further improving stability before and after post-baking, the pigment preferably contains a blue pigment (particularly, at least one kind selected from the group consisting of C. I. Pigment Blue 15:3, C. I. Pigment Blue 15:4, and C. I. Pigment Blue 15:6).

These pigments may be subjected to a rosin treatment, a surface treatment using a pigment derivative or the like having an introduced acidic group or basic group, a pigment surface graft treatment with a polymeric compound or the like, a particle micronization treatment with a sulfuric acid micronization method or the like, a washing treatment with an organic solvent, water or the like for removing impurities, a removing treatment with an ionic exchange method or the like of ionic impurities or the like, if required. The pigment preferably has a substantially uniform particle diameter. To the pigment, a pigment dispersant is added, followed by performing a dispersion treatment, whereby a pigment dispersion in which the pigment is uniformly dispersed in a pigment dispersant solution can be produced. The pigments may be each independently subjected to a dispersion treatment, or the plurality of pigments may be mixed, followed by performing a dispersion treatment.

Examples of the pigment dispersant include surfactants such as a cationic surfactant, an anionic surfactant, a non-ionic surfactant, and an amphoteric surfactant. Specific examples thereof include surfactants such as a polyester-based surfactant, a polyamine-based surfactant, and an acrylic surfactant. These pigment dispersants are optionally used singly or in combination of two or more thereof. Examples in trade names of the pigment dispersant include KP (manufactured by Shin-Etsu Chemical Co., Ltd.), Flowlen (manufactured by Kyoeisha Chemical Co., Ltd.), Solsperse (registered trademark) (manufactured by Zeneca Ltd.), EFKA (registered trademark) (manufactured by BASF Corporation), AJISPER (registered trademark) (manufactured by Ajinomoto Fine-Techno Co., Inc.), Disperbyk (registered trademark) (manufactured by BYK-Chemie Corporation), and BYK (registered trademark) (manufactured by BYK-Chemie Corporation).

When the pigment dispersant is used, the amount thereof used is preferably 10 parts by mass or more and 200 parts by mass or less, more preferably 15 parts by mass or more and 180 parts by mass or less, and still more preferably 20 parts by mass or more and 160 parts by mass or less, based on 100 parts by mass of the pigment. When the amount of the pigment dispersant used falls within the range, and two or more pigments are used, a pigment dispersion in the form of a more uniform dispersion tends to be obtained.

When the colorant (A) contains the colorant (A2), the content rate of the colorant (A2) is preferably 1 to 80% by mass, more preferably 1 to 70% by mass, and still more preferably 1 to 60% by mass in the whole amount of the colorant (A). The content rate of the colorant (A2) is optionally 5% by mass or more, 10% by mass or more, and 20% by mass or more in the whole amount of the colorant (A). The content rate of the colorant (A2) is optionally 40% by mass or less, 20% by mass or less, or 10% by mass or less in the whole amount of the colorant (A) .

The content rate of the colorant (A) in the colored resin composition is preferably 0.5 to 80% by mass, more preferably 1 to 70% by mass, still more preferably 2 to 55% by mass, and particularly preferably 8 to 50% by mass, relative to the whole amount of the solid content. When the content rate of the colorant (A) falls within the above-mentioned range, desired spectroscopy and color density are more likely to be obtained.

### <Resin (B)>

The resin (B) is not particularly limited, and is preferably an alkali soluble resin. Examples of the resin (B) include the following resins [K1] to [K6].
Resin [K1]; a copolymer having at least one monomer (a) selected from the group consisting of an unsaturated carboxylic acid and an unsaturated carboxylic anhydride (hereinafter, sometimes referred to as "(a)") and a monomer (b) having a cyclic ether structure having 2 to 4 carbon atoms and an ethylenically unsaturated bond (hereinafter, sometimes referred to as "(b)");
Resin [K2]; a copolymer having (a), (b), and a monomer (c) copolymerizable with (a) (provided that (c) is different from (a) and (b)) (hereinafter, sometimes referred to as "(c)");
Resin [K3]; a copolymer having (a) and (c);
Resin [K4]; a resin produced by reacting (b) with a copolymer having (a) and (c);
Resin [K5]; a resin produced by reacting (a) with a copolymer having (b) and (c); and
Resin [K6]; a resin produced by reacting (a) with a copolymer having (b) and (c), and further reacting polycarboxylic acid and/or a carboxylic anhydride with the reaction product.

Specific examples of (a) include unsaturated monocarboxylic acids such as acrylic acid, methacrylic acid, crotonic acid, and o-, m- or p-vinylbenzoic acid;
unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;
carboxy group-containing bicyclo unsaturated compounds such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;
unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;
unsaturated mono[(meth)acryloyloxyalkyl]esters of a polyvalent carboxylic acid having a valence of 2 or more such as succinic acid mono[2-(meth)acryloyloxyethyl], and phthalic acid mono[2-(meth)acryloyloxyethyl]; and
unsaturated acrylates containing a hydroxy group and a carboxy group in the same molecule such as α-(hydroxymethyl)acrylic acid.

Among these, from the viewpoint of copolymerization reactivity and solubility of a resin to be produced to an alkaline aqueous solution, acrylic acid, methacrylic acid, maleic anhydride and the like are preferable.

(b) means a polymerizable compound having, for example, a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether having 2 to 4 carbon atoms and a (meth)acryloyloxy group.

As used herein, "(meth)acrylic acid" represents at least one selected from the group consisting of acrylic acid and methacrylic acid. The terms "(meth)acryloyl", "(meth)acrylate" and the like also have similar meanings.

Examples of (b) include a monomer having an oxiranyl group and an ethylenically unsaturated bond (b1) (hereinafter, sometimes referred to as "(bl)"), a monomer having an oxetanyl group and an ethylenically unsaturated bond (b2) (hereinafter, sometimes referred to as "(b2)"), and a monomer having a tetrahydrofuryl group and an ethylenically unsaturated bond (b3) (hereinafter, sometimes referred to as "(b3)").

Examples of (b1) include a monomer having a structure where a linear or branched aliphatic unsaturated hydrocarbon is epoxidized (b1-1) (hereinafter, sometimes referred to as "(b1-1)") and a monomer having a structure where an alicyclic unsaturated hydrocarbon is epoxidized (b1-2) (hereinafter, sometimes referred to as "bl-2").

Examples of (b1-1) include glycidyl(meth)acrylate, β-methylglycidyl(meth)acrylate, β-ethylglycidyl(meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl)styrene.

Examples of (bl-2) include vinylcyclohexene monoxide, 1,2-epoxy-4-vinylcyclohexane (for example, Celloxide 2000; manufactured by Daicel Corporation), 3,4-epoxycyclohexylmethyl(meth)acrylate (for example, Cyclomer A400; manufactured by Daicel Corporation), 3,4-epoxycyclohexylmethyl(meth)acrylate (for example, Cyclomer M100; manufactured by Daicel Corporation), 3,4-epoxytricyclo[5.2.1.0^{2,6}]decyl(meth)acrylate, a compound represented by formula (R1), and a compound represented by (R2).

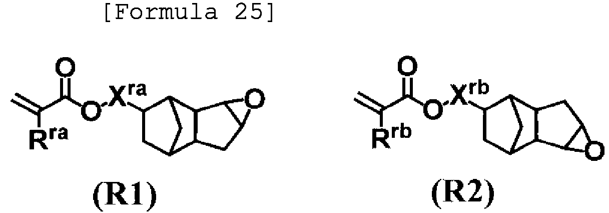

[In formula (R1) and formula (R2), R^{ra} and R^{rb} each represent a hydrogen atom or an alkyl group having 1 to 4 carbon atoms, and a hydrogen atom contained in the alkyl group is optionally replaced with a hydroxy group.
X^{ra} and X^{rb} each represent a single bond, *-R^{rc}-, *-R^{rc}-O-, *-R^{rc}-S-, or *-R^{rc}-NH-,
R^{rc} represents an alkanediyl group having 1 to 6 carbon atoms, and
* represents a bond with O.]

Examples of the alkyl group having 1 to 4 carbon atoms include a methyl group, an ethyl group, a n-propyl group, an isopropyl group, a n-butyl group, a sec-butyl group and a tert-butyl group.

Examples of the alkyl group with a hydrogen atom replaced with a hydroxy group include a hydroxymethyl group, a 1-hydroxyethyl group, a 2-hydroxyethyl group, a 1-hydroxypropyl group, a 2-hydroxypropyl group, a 3-hydroxypropyl group, a 1-hydroxy-1-methylethyl group, a 2-hydroxy-1-methylethyl group, a 1-hydroxybutyl group, a 2-hydroxybutyl group, a 3-hydroxybutyl group, and a 4-hydroxybutyl group.

R^{ra} and R^{rb} are each preferably a hydrogen atom, a methyl group, a hydroxymethyl group, a 1-hydroxyethyl group or a 2-hydroxyethyl group, and more preferably a hydrogen atom or a methyl group.

Examples of the alkanediyl group include a methylene group, an ethylene group, a propane-1,2-diyl group, a propane-1,3-diyl group, a butane-1,4-diyl group, a pentane-1,5-diyl group, and a hexane-1,6-diyl group.

X^{ra} and X^{rb} are each preferably a single bond, a methylene group, an ethylene group, *-CH₂-O-, and *-CH₂CH₂-O-, and more preferably a single bond or *-CH₂CH₂-O- (* represents a bond with O).

Examples of the compound represented by formula (R1) include a compound represented by any of formula (R1-1) to formula (R1-15). Among these, the compound is preferably a compound represented by formula (R1-1), formula (R1-3), formula (R1-5), formula (R1-7), formula (Rl-9), or formula (R1-11) to formula (R1-15), and more preferably a compound represented by formula (R1-1), formula (R1-7), formula (R1-9), or formula (R1-15).

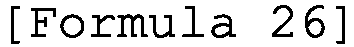

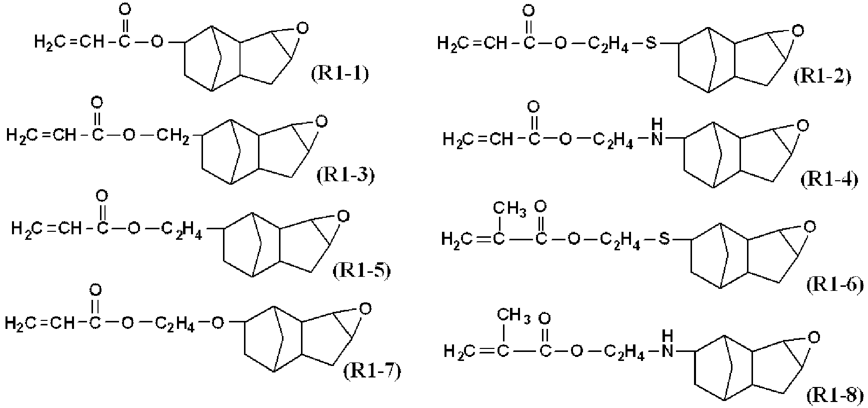

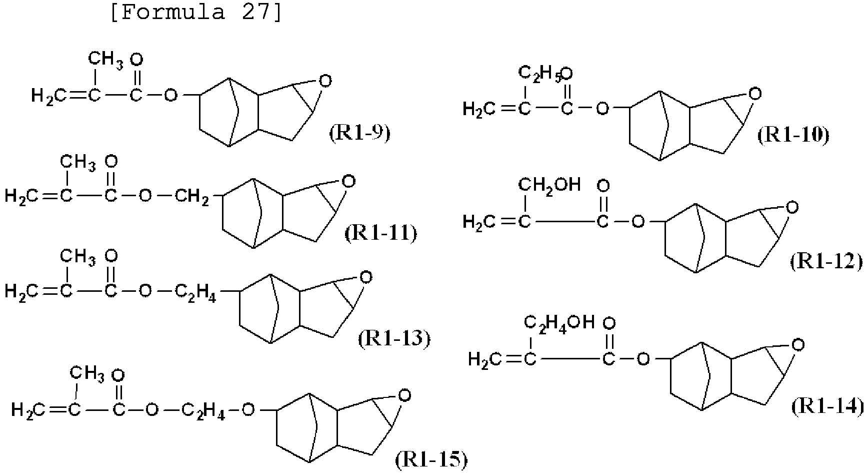

Examples of the compound represented by formula (R2) include a compound represented by any of formula (R2-1) to formula (R2-15). Among these, the compound is preferably a compound represented by formula (R2-1), formula (R2-3), formula (R2-5), formula (R2-7), formula (R2-9), or formula (R2-11) to formula (R2-15), and more preferably a compound represented by formula (R2-1), formula (R2-7), formula (R2-9), or formula (R2-15).

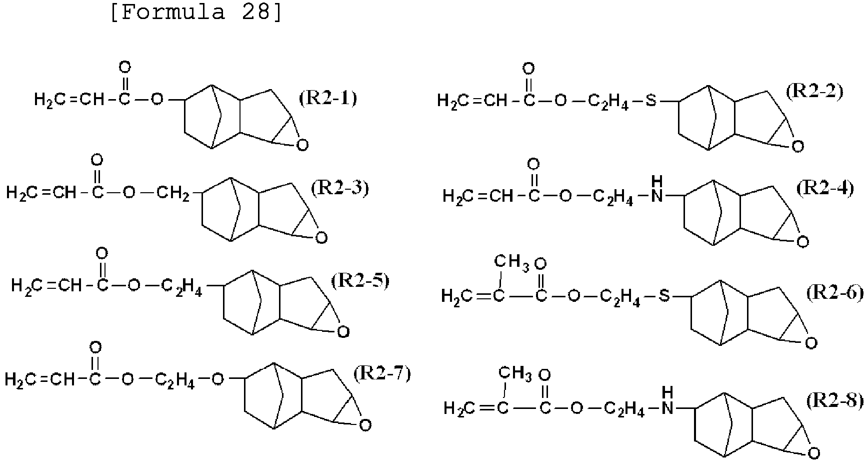

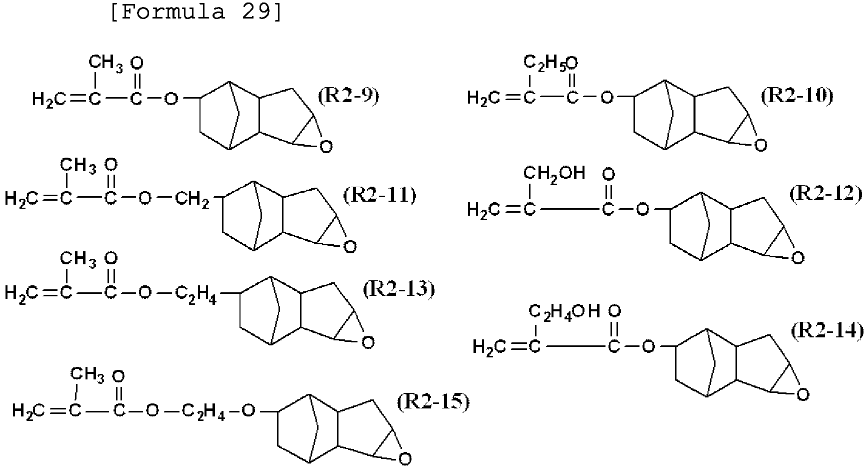

(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.

(b3) is more preferably a monomer having a tetrahydrofuryl group and a (meth)acryloyloxy group. Specific examples of (b3) include tetrahydrofurfuryl acrylate (for example, Viscoat V#150, manufactured by Osaka Organic Chemical Industry Ltd.) and tetrahydrofurfuryl methacrylate.

(b) is preferably (b1) since reliabilities such as heat resistance and chemical resistance of a color filter to be produced can be further improved. Furthermore, (b1-2) is more preferable since the storage stability of the colored resin composition is excellent.

Examples of (c) include (meth)acrylic esters such as methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0^{2,6}]decan-8-yl(meth)acrylate (referred to as "dicyclopentanyl(meth)acrylate" (common name) in the art or sometimes referred to as "tricyclodecyl(meth)acrylate"), tricyclo[5.2.1.0^{2,6}]decene-8-yl(meth) acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;
hydroxy group-containing (meth)acrylic esters such as 2-hydroxyethyl(meth)acrylate and 2-hydroxypropyl(meth)acrylate;
dicarboxylic diesters such as diethyl maleate, diethyl fumarate, and diethyl itaconate;
bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo[2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;
dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;
styrene, α-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

(c) is preferably 2-ethylhexyl(meth)acrylate, dicyclopentanyl(meth)acrylate, benzyl(meth)acrylate, styrene, vinyltoluene, N-phenylmaleimide, N-cyclohexylmaleimide, N-benzylmaleimide, and bicyclo[2.2.1]hept-2-ene and the like, and more preferably styrene, vinyltoluene, N-phenylmaleimide, N-cyclohexylmaleimide, N-benzylmaleimide, and bicyclo[2.2.1]hept-2-ene and the like from the viewpoint of copolymerization reactivity and heat resistance.

In the resin [Kl], the ratio of the structural unit derived from each of (a) and (b) in the total structural units constituting the resin [K1] is preferably the following:
the structural unit derived from (a); 2 to 60 mol%; and the structural unit derived from (b); 40 to 98 mol%,
and more preferably the following:
   the structural unit derived from (a); 10 to 50 mol%; and the structural unit derived from (b); 50 to 90 mol%.

When the ratio of the structural unit of the resin [K1] falls within the above-mentioned range, there is a tendency that the storage stability of the colored resin composition, that the developability thereof during the formation of a colored pattern, and that the solvent resistance of a color filter to be produced are excellent.

The resin [K1] can be produced with reference to the method described in for example, a document "Experimental Method for Polymer Synthesis" (edited by Takayuki Otsu, published by Kagaku Dojin Publishing Co., Ltd., First Edition, First Printed on Mar. 1, 1972) and cited documents described in the above-mentioned document.

Specific examples thereof include the following method: predetermined amounts of (a) and (b), a polymerization initiator, and a solvent and the like are placed in a reaction vessel; for example, a deoxidization atmosphere is formed by substituting oxygen with nitrogen; and these are heated or kept warm during stirring. The polymerization initiator, the solvent and the like which are used here are not particularly limited, and those commonly used in the art can be used. Examples of the polymerization initiator include azo compounds (2,2'-azobisisobutyronitrile, 2,2'-azobis(2,4-dimethylvaleronitrile) and the like) and organic peroxides (benzoyl peroxide and the like). The solvent may be a solvent capable of dissolving each monomer, and examples of the solvent (E) include solvents to be described later.

A solution after a reaction, of the resultant copolymer may be used as it is; a concentrated or diluted solution of the copolymer may be used; or a solid (powder) taken out from the copolymer by a method such as reprecipitation may be used. In particular, the solution after the reaction can be used as it is for preparing the colored resin composition by using the solvent contained in the colored resin composition as the solvent during the polymerization, whereby the producing process of the colored resin composition can be simplified.

In the resin [K2], the ratio of the structural unit derived from each of (a) to (c) in the total structural units constituting the resin [K2] is preferably the following:
the structural unit derived from (a); 2 to 45 mol%;
the structural unit derived from (b); 2 to 95 mol%; and the structural unit derived from (c); 1 to 65 mol%,
and more preferably the following:
   the structural unit derived from (a); 5 to 40 mol%;
   the structural unit derived from (b); 5 to 80 mol%; and
   the structural unit derived from (c); 5 to 60 mol%.

When the ratio of the structural unit of the resin [K2] falls within the above-mentioned range, there is a tendency that the storage stability of the colored resin composition, the developability thereof during the formation of a colored pattern, and the solvent resistance, heat resistance, and mechanical strength of a color filter to be produced are excellent.

The resin [K2] can be produced in the same manner as in the method described as the producing method of the resin [Kl], for example.

In the resin [K3], the ratio of the structural unit derived from each of (a) and (c) in the total structural units constituting the resin [K3] is preferably the following:
the structural unit derived from (a); 2 to 60 mol%; and
the structural unit derived from (c); 40 to 98 mol%,
and more preferably the following:
   the structural unit derived from (a); 10 to 50 mol% and the structural unit derived from (c); 50 to 90 mol%.

The resin [K3] can be produced in the same manner as in the method described as the producing method of the resin [Kl], for example.

The resin [K4] can be produced by producing a copolymer of (a) and (c) and then adding a cyclic ether having 2 to 4 carbon atoms contained in (b) to a carboxylic acid and/or a carboxylic anhydride contained in (a).

The copolymer of (a) and (c) is first produced in the same manner as in the method described as the producing method of the resin [K1]. In this case, the ratio of the structural unit derived from each of (a) and (c) is preferably the same ratio as that described in the resin [K3].

Next, a cyclic ether having 2 to 4 carbon atoms contained in (b) is reacted with a part of the carboxylic acid and/or the carboxylic anhydride derived from (a) in the copolymer.

Subsequent to the production of the copolymer of (a) and (c), a nitrogen atmosphere in a flask is replaced with air, and (b), a reaction catalyst for a carboxylic acid or a carboxylic anhydride and a cyclic ether (for example, tris(dimethylaminomethyl)phenol and the like), and a polymerization inhibitor (for example, hydroquinone and the like) are placed in a flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). The amount of (b) used falls within the above-mentioned range, whereby there is a tendency that the storage stability of the colored resin composition, the developability thereof during the formation of a pattern, and the balance of the solvent resistance, heat resistance, mechanical strength, and sensitivity of the pattern obtained are good. Since the reactivity of the cyclic ether is high, and the unreacted (b) is less likely to remain, (b) used for the resin [K4] is preferably (bl), and more preferably (b1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

The resin [K5] is produced by producing a copolymer of (b) and (c) in the same manner as in the above-mentioned method for producing the resin [K1] as a first step. In the same manner as in the above, a solution after a reaction, of the resultant copolymer may be used as it is; a concentrated or diluted solution of the copolymer may be used; or a solid (powder) taken out from the copolymer by a method such as reprecipitation may be used.

The ratio of the structural unit derived from each of (b) and (c) relative to the total number of mols of the total structural units constituting the copolymer is preferably the following:
the structural unit derived from (b); 5 to 95 mol%; and
the structural unit derived from (c); 5 to 95 mol%, and more preferably the following:
   the structural unit derived from (b); 10 to 90 mol%; and
   the structural unit derived from (c); 10 to 90 mol%.

Furthermore, the resin [K5] can be produced by reacting a carboxylic acid or a carboxylic anhydride contained in (a) with the cyclic ether derived from (b) contained in the copolymer of (b) and (c) under the same conditions as those of the producing method of the resin [K4] .

The amount of (a) used which is reacted with the copolymer is preferably 5 to 100 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. A carboxylic anhydride is reacted with a hydroxy group generated by a reaction between a cyclic ether and a carboxylic acid or a carboxylic anhydride.

Examples of the carboxylic anhydride include succinic anhydride, maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.1 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.0^{2,6}]decyl acrylate/(meth)acrylic acid copolymer; a resin [K2] such as a 3,4-epoxytricyclo[5.2.1.0^{2,6}]decyl acrylate/benzyl(meth)acrylate/(meth)acrylic acid copolymer, a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.0^{2,6}]decyl acrylate/(meth)acrylic acid/N-cyclohexylmaleimide copolymer, 3,4-epoxytricyclo[5.2.1.0^{2,6}]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)ac rylic acid copolymer; a resin [K5] such as a resin produced by reacting a tricyclodecyl(meth)acrylate/glycidyl(meth)acrylate copolymer with (meth)acrylic acid or a resin produced by reacting a tricyclodecyl(meth)acrylate/styrene/glycidyl(meth)acrylat e copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with tetrahydrophthalic anhydride, or a resin produced by reacting a 2-ethylhexyl(meth)acrylate/glycidyl(meth)acrylate/dicyclope ntenyl(meth)acrylate copolymer with (meth)acrylic acid to produce a resin and then reacting this resin with succinic anhydride.

Among these, the resin (B) is preferably a copolymer having a structural unit derived from at least one selected from the group consisting of an unsaturated carboxylic acid and an unsaturated carboxylic anhydride and a structural unit having a cyclic ether structure having 2 to 4 carbon atoms and an ethylenically unsaturated bond (resin [K1] or resin [K2]), or the resin [K6], and more preferably the resin [K1] or the resin [K2].

The weight average molecular weight of the resin (B) in terms of polystyrene content is preferably 500 to 100,000, more preferably 600 to 50,000, and still more preferably 700 to 30,000. When the molecular weight falls within the above-mentioned range, there is a tendency that the hardness of the color filter is improved, that the residual film ratio is increased, that the solubility of an unexposed area in a developing solution becomes good, and that the resolution of a colored pattern is improved.

The degree of dispersion [weight average molecular weight (Mw)/number average molecular weight (Mn)] of the resin (B) is preferably 1.1 to 6, and more preferably 1.2 to 4.

The acid value of the resin (B) is preferably 10 to 170 mg-KOH/g, more preferably 20 to 150 mg-KOH/g, and still more preferably 30 to 135 mg-KOH/g, in terms of solid content. The acid value as used herein is a value which is measured as an amount (mg) of potassium hydroxide required for neutralizing 1 g of the resin (B), and which can be determined by, for example, titration with an aqueous potassium hydroxide solution.

The content rate of the resin (B) is preferably 7 to 80% by mass, more preferably 13 to 75% by mass, still more preferably 17 to 70% by mass, and yet still more preferably 17 to 55% by mass, relative to the whole amount of the solid content. When the content rate of the resin (B) falls within the above-mentioned range, there is a tendency that the colored pattern can be formed, and that the resolution of the colored pattern and the residual film ratio are improved.

### <Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and is preferably a (meth)acrylic acid ester compound.

Among these, the polymerizable compound (C) is preferably a polymerizable compound having three or more ethylenically unsaturated bonds. Examples of the polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, it is preferable to contain at least one selected from the group consisting of trimethylolpropane tri(meth)acrylate, dipentaerythritol penta(meth)acrylate, and dipentaerythritol hexa(meth)acrylate, and it is more preferable to contain at least one selected from the group consisting of trimethylolpropane triacrylate, dipentaerythritol pentaacrylate, and dipentaerythritol hexaacrylate.

The weight average molecular weight of the polymerizable compound (C) is preferably 150 or more and 2,900 or less, and more preferably 250 or more and 1,500 or less.

When the colored resin composition of the present invention contains the polymerizable compound (C), the content rate of the polymerizable compound (C) is preferably 7 to 65% by mass, more preferably 13 to 60% by mass, and still more preferably 17 to 55% by mass, relative to the whole amount of the solid content. When the content rate of the polymerizable compound (C) falls within the above-mentioned range, there is a tendency that the residual film ratio during the formation of the colored pattern and the chemical resistance of the color filter are improved.

### <Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used.

Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

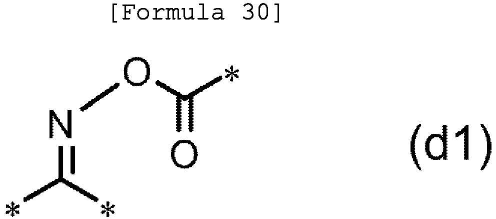

Examples of the O-acyloxime compound include N-benzoyloxy-1-(4-phenylsulfanylphenyl)butane-1-one-2-imine, N-benzoyloxy-1-(4-phenylsulfanylphenyl)octane-1-one-2-imine, N-benzoyloxy-1-(4-phenylsulfanylphenyl)-3-cyclopentylpropane-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, N-benzoyloxy-1-[9-ethyl-6-(2-methylbenzoyl)-9H-carbazole-3-yl]-3-cyclopentylpropane-1-one-2-imine, and N-acetyloxy-1-(4-phenylsulfanylphenyl)-3-cyclohexylpropane-1-one-2-imine. Commercially available products such as Irgacure OXE01, OXE02 and OXE03 (all manufactured by BASF Corporation), N-1919 (manufactured by ADEKA Corporation), and TR-PBG327 (manufactured by Changzhou Tronly New Electronic Materials Co., Ltd.) may be used. Among these, the O-acyloxime compound is preferably at least one selected from the group consisting of N-acetyloxy-1-(4-phenylsulfanylphenyl)-3-cyclohexylpropane-1-one-2-imine, N-benzoyloxy-1-(4-phenylsulfanylphenyl)butane-1-one-2-imine, N-benzoyloxy-1-(4-phenylsulfanylphenyl)octane-1-one-2-imine, and N-benzoyloxy-1-(4-phenylsulfanylphenyl)-3-cyclopentylpropane-1-one-2-imine, and more preferably N-acetyloxy-1-(4-phenylsulfanylphenyl)-3-cyclohexylpropane-1-one-2-imine, and N-benzoyloxy-1-(4-phenylsulfanylphenyl)octane-1-one-2-imine. There is a tendency that these O-acyloxime compounds provide a color filter having a high brightness.

The alkylphenone compound is a compound having a partial structure represented by formula (d2) or a partial structure represented by formula (d3). In these partial structures, the benzene ring optionally has a substituent.

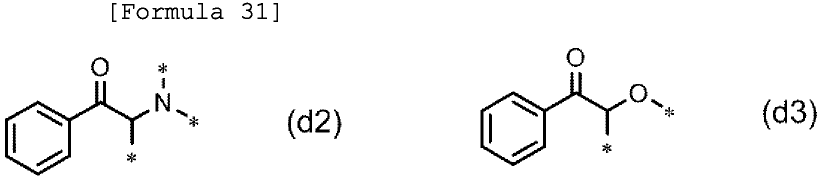

Examples of the compound having a partial structure represented by formula (d2) include 2-methyl-2-morpholino-1-(4-methylsulfanylphenyl)propane-1-one, 2-dimethylamino-1-(4-morpholinophenyl)-2-benzylbutane-1-one, and 2-(dimethylamino)-2-[(4-methylphenyl)methyl]-1-[4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, α,α-diethoxyacetophenone, and benzyl dimethyl ketal.

The alkylphenone compound is preferably a compound having a partial structure represented by formula (d2) from the viewpoint of sensitivity.

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. 6-75372 and Japanese Patent Laid-Open No. 6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent No. 48-38403 and Japanese Patent Laid-Open No. 62-174204), and a biimidazole compound in which a phenyl group at the 4,4',5,5' position is substituted with a carboalkoxy group (for example, see Japanese Patent Laid-Open No. 7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenonne, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, an amine compound) to be described later.

Examples of a polymerization initiator which generates an acid include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenylmethylbenzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate, nitrobenzyl tosylates, and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

When the colored resin composition of the present invention contains the polymerization initiator (D), the content rate of the polymerization initiator (D) is preferably 0.1 to 30 parts by mass, and more preferably 1 to 20 parts by mass, relative to 100 parts by mass of the whole amount of the resin (B) and the polymerizable compound (C). When the content of the polymerization initiator (D) falls within the above-mentioned range, there is a tendency that the sensitivity is increased and that the time of exposure to light is shortened, resulting in the improvement in productivity of the color filter.

### <Polymerization Initiation Aid (Dl)>

The polymerization initiation aid (D1) is a compound to be used for accelerating polymerization of a polymerizable compound the polymerization of which has been started by the polymerization initiator or a sensitizer. When the polymerization initiation aid (D1) is contained, the polymerization initiation aid (D1) is commonly used in combination with the polymerization initiator (D).

Examples of the polymerization initiation aid (D1) include an amine compound, an alkoxyanthracene compound, a thioxanthone compound, and a carboxylic acid compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone. Among these, 4,4'-bis(diethylamino)benzophenone is preferable. Commercially available products such as EAB-F (manufactured by Hodogaya Chemical Co., Ltd.), may be used.

Examples of the alkoxy anthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the polymerization initiation aid (D1) is used, the content thereof is preferably 0.1 to 30 parts by mass, and more preferably 1 to 20 parts by mass, relative to 100 parts by mass of the whole amount of the resin (B) and the polymerizable compound (C). When the amount of the polymerization initiation aid (D1) falls within the above-mentioned range, there is a tendency that the colored pattern can be formed with higher sensitivity, resulting in the improvement in productivity of the color filter.

### <Solvent (E)>

The solvent (E) is not particularly limited, and any solvent which has been used conventionally in the art can be used. Examples of the solvent (E) include an ester solvent (a solvent which contains -COO- but does not contain -O- in its molecule), an ether solvent (a solvent which contains -O- but does not contain -COO- in its molecule), an ether ester solvent (a solvent which contains -COO- and -O- in its molecule), a ketone solvent (a solvent which contains -CO- but does not contain -COO-in its molecule), an alcohol solvent (a solvent which contains OH but does not contain -O-, -CO- nor -COO- in its molecule), an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-butyl methoxyacetate, 3-methyl-3-butyl methoxyacetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone (diacetone alcohol), acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin.

Examples of the aromatic hydrocarbon solvent include benzene, toluene, xylene, and mesitylene.

Examples of the above amide solvent include N,N-dimethylformamide, N,N-dimethylacetamide, and N-methylpyrrolidone.

The solvent (E) is preferably at least one or more selected from the group consisting of an ether solvent, an ether ester solvent, a ketonic solvent, and an amide solvent, and more preferably contains at least one or more selected from the group consisting of diethylene glycol methylethyl ether, propylene glycol monomethyl ether acetate, diacetone alcohol, and N-methylpyrrolidone.

The content rate of the solvent (E) is preferably 70 to 95% by mass, and more preferably 75 to 92% by mass, relative to the whole amount of the colored resin composition. In other words, the solid content of the colored resin composition is preferably 5 to 30% by mass, and more preferably 8 to 25% by mass. When the content rate of the solvent (E) falls within the above-mentioned range, there is a tendency that the flatness during application becomes good and the color density of the color filter formed becomes not insufficient, resulting in the achievement of good displaying properties.

### <Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name: manufactured by Dow Corning Toray Co., Ltd.); KP321, KP322, KP323, KP324, KP326, KP340, and KP341 (manufactured by Shin-Etsu Silicone Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by AGC Inc. (former Asahi Glass Co., Ltd.)); and E5844 (manufactured by Daikin Finechemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

When the colored resin composition of the present invention contains the leveling agent (F), the content rate of the leveling agent (F) is preferably 0.001 to 0.2% by mass, more preferably 0.002 to 0.1% by mass, and still more preferably 0.005 to 0.05% by mass, relative to the whole amount of the colored resin composition. This content rate does not include the content rate of the pigment dispersant. When the content rate of the leveling agent (F) falls within the above-mentioned range, the flatness of the color filter can be improved.

### <Other Components>

If required, the colored resin composition may contain an additive known in the art, such as a filler, other polymeric compound, an adhesion promoter, an antioxidant, a light stabilizer, or a chain transfer agent.

### <Method for Producing Colored Resin Composition>

The colored resin composition can be prepared by, for example, mixing a colorant (A) containing a compound (I) and a resin (B), as well as a polymerizable compound (C), a polymerization initiator (D), a solvent (E), a leveling agent (F), a polymerization initiation aid (D1), and other components to be used if necessary.

The compound (I) and other components to be used if necessary are optionally contained in advance in a pigment dispersion. A desired colored resin composition can be prepared by mixing remaining components at predetermined concentrations in the pigment dispersion.

When the colored resin composition contains a dye, the dye may be dissolved in advance in a part of or whole of the solvent (E) to prepare a solution. The solution is preferably filtered by a filter having a pore size of about 0.01 to 1 µm.

The colored resin composition after mixing is preferably filtered by a filter having a pore size of about 0.01 to 10 µm.

### [Color Filter]

Examples of the method for producing a colored pattern of a color filter from the colored resin composition of the present invention include a photolithography method, an inkjet method, and a printing method. Among these methods, a photolithography method is preferable. The photolithography method is a method in which the colored resin composition is applied onto a substrate and then dried to form a composition layer, and the composition layer is then developed by exposing the composition layer to light through a photomask. In the photolithography method, the photomask is not used during the exposure to light, and/or the composition layer is not developed, whereby a colored coating film which is a hardened material of the composition layer can be formed.

The film thickness of the color filter (cured film) is, for example, 30 µm or less, preferably 20 µm or less, more preferably 6 µm or less, still more preferably 3 µm or less, yet still more preferably 1.5 µm or less, and particularly preferably 0.5 µm or less; and preferably 0.1 µm or more, more preferably 0.2 µm or more, and still more preferably 0.3 µm or more.

Examples of the substrate to be used include glass substrates such as quartz glass, borosilicate glass, alumina silicate glass, and soda lime glass of which the surface is coated with silica; resin substrates such as polycarbonate, poly(methyl methacrylate), and polyethylene terephthalate; silicon; and substrates on which aluminum, silver, or a silver/copper/palladium alloy thin film or the like is formed. On such a substrate, another color filter layer, a resin layer, a transistor, and a circuit and the like are optionally formed. A substrate obtained by subjecting a silicon substrate to HMDS treatment is also optionally used.

The formation of each color pixel using a photolithography method can be carried out using a known or conventional device or under known or conventional conditions. For example, the color pixel can be prepared in the following manner. First, a colored resin composition is applied onto a substrate, and then dried by heat-drying (prebaking) and/or drying under reduced pressure to remove volatile components such as a solvent from the composition, thereby producing a smooth composition layer. Examples of the application method include a spin coat method, a slit coat method, and a slit-and-spin coat method. The temperature to be employed when heat-drying is carried out is preferably 30 to 120°C, and more preferably 50 to 110°C. The time for the heating is preferably 10 seconds to 60 minutes, and more preferably 30 seconds to 30 minutes. When drying under reduced pressure is carried out, the drying procedure is preferably carried out at a temperature range of 20 to 25°C under a pressure of 50 to 150 Pa. The film thickness of the composition layer is not particularly limited, and may be selected appropriately depending on the desired film thickness of the color filter.

Next, the composition layer is exposed to light through a photomask for forming a desired colored pattern. The pattern on the photomask is not particularly limited, and a pattern suitable for the intended application is used. A light source to be used for the exposure to light is preferably a light source capable of generating light having a wavelength of 250 to 450 nm. For example, light having a wavelength of shorter than 250 nm may be cut with a filter capable of cutting light having this wavelength region, or light having a wavelength of around 436 nm, around 408 nm, or around 365 nm may be extracted selectively with a bandpass filter capable of extracting light having those wavelength region. Specific examples thereof include a mercury lamp, a light-emitting diode, a metal halide lamp, and a halogen lamp. A reduction projection exposure apparatus such as a mask aligner and a stepper, or a proximity exposure apparatus is preferably used because these apparatuses are capable of emitting a parallel light beam uniformly over the whole area of the exposed surface or accurately aligning the photomask to the substrate.

A colored pattern is formed on the substrate by bringing the exposed composition layer into contact with a developing solution to develop the composition layer. By developing, an unexposed area in the composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01 to 10% by mass, and more preferably 0.03 to 5% by mass. The developing solution may further contain a surfactant. The developing method may be any of a paddle method, a dipping method, a spray method and the like. Furthermore, during the developing process, the substrate may be inclined at any angle.

After the developing process, the resultant product is preferably washed with water.

Furthermore, the resultant colored pattern is preferably subjected to post-baking. The temperature for the post-baking is preferably 80 to 250°C, and more preferably 100 to 245°C. The time for the post-baking is preferably 1 to 120 minutes, and more preferably 2 to 30 minutes.

The colored pattern and the colored coating film thus produced are useful as a color filter. The color filter is useful as a color filter used for display devices (for example, a liquid crystal display device or an organic EL device), an electronic paper, and a solid-state image sensor and the like.

### Examples

Hereinafter, the present invention will be described in more detail with reference to Examples. However, of course, the present invention is not limited to the following Examples. Unless otherwise specified in Examples, "parts" means "parts by mass" and "%" means "% by mass".

The structures of compounds were identified by mass spectrometry (MALDI-TOF MS; JMS-S3000 manufactured by JEOL Ltd.).

### (Synthesis of Colorant)

### [Example 1]

To 6.7 parts of phenyl dichlorophosphate (manufactured by Tokyo Chemical Industry Co., Ltd.) and 11 parts of tetrahydrofuran (manufactured by FUJIFILM Wako Pure Chemical Corporation) was added dropwise a solution prepared from 2.1 parts of 3-butyn-1-ol (manufactured by Tokyo Chemical Industry Co., Ltd.) and 11 parts of tetrahydrofuran at 0°C. Subsequently, to this mixture was added dropwise a solution prepared from 7.6 parts of triethylamine (manufactured by Tokyo Chemical Industry Co., Ltd.) and 11 parts of tetrahydrofuran at 0°C. Thereafter, the resultant mixture was stirred at room temperature for 3 hours, and then 33 parts of ion exchange water was charged thereto. The obtained solution was separated with chloroform (manufactured by FUJIFILM Wako Pure Chemical Corporation) to take out an organic layer. After drying with sodium sulfate, the solvent was removed using a rotary evaporator. The resultant mixture was purified with a silica gel column to obtain 2.8 parts of a compound represented by formula (1).

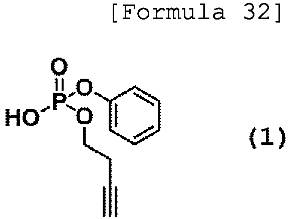

To 4.3 parts of triethylamine (manufactured by Tokyo Chemical Industry Co., Ltd.) and 4.3 parts of dimethyl sulfoxide (manufactured by Tokyo Chemical Industry Co., Ltd.), 0.86 parts of a compound represented by formula (1), 0.5 parts of 1,3-diiodobenzene (manufactured by Tokyo Chemical Industry Co., Ltd.), 0.13 parts of dichlorobistriphenylphosphine palladium (manufactured by Tokyo Chemical Industry Co., Ltd.), and 0.18 parts of copper iodide (manufactured by FUJIFILM Wako Pure Chemical Corporation) were added, followed by stirring at room temperature for 8 hours. Then, 26 parts of a 1 N aqueous sodium hydroxide solution was added to the mixture at room temperature, followed by stirring and removing a precipitation solid by celite. The obtained aqueous solution was separated with ethyl acetate to take out a water layer. To the water layer was added concentrated hydrochloric acid to acidify the water layer, and then the resultant was separated again with ethyl acetate to take out an organic layer. After the obtained organic layer was dried with sodium sulfate, the solvent was removed using a rotary evaporator to obtain 0.76 parts of a compound represented by formula (2).

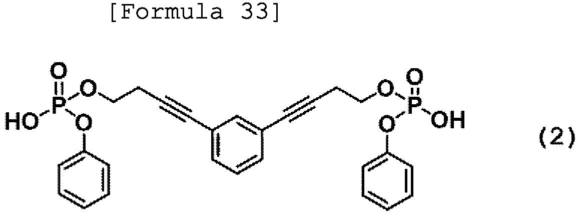

1.2 parts of a compound represented by formula (3) (manufactured by Tokyo Chemical Industry Co., Ltd.), 0.76 parts of a compound represented by formula (2), and 5.9 parts of dimethyl sulfoxide (manufactured by Tokyo Chemical Industry Co., Ltd.) were mixed at room temperature, followed by temperature rise to 80°C and stirring for 6 hours. After the reaction liquid was cooled to room temperature, 30 parts of ion exchange water was charged to the reaction liquid. The obtained deposit was acquired as a residue of suction filtration, and washed with 30 parts of ethyl acetate (manufactured by FUJIFILM Wako Pure Chemical Corporation). Then, the resultant was dried under reduced pressure upon heating at 60°C to obtain 1.3 parts of a compound represented by formula (4).

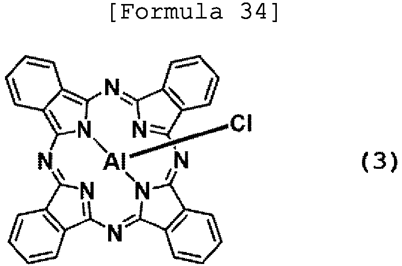

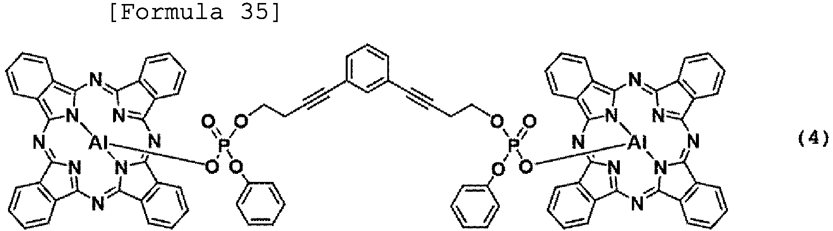

### Identification of compound represented by formula (4)

### (Mass spectrometry)

Ionization mode=MALDI-TOF⁻: m/z=1602.4
Exact Mass: 1602.3

### [Example 2]

In a reaction in which a compound represented by formula (2) of Example 1 is obtained, 1,3-diiodobenzene to be used was changed to 1,4-diiodobenzene (manufactured by Tokyo Chemical Industry Co., Ltd.), to obtain a compound represented by formula (5).

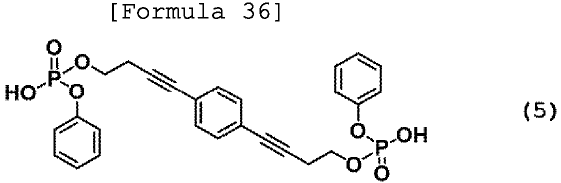

1.5 parts of a compound represented by formula (3) (manufactured by Tokyo Chemical Industry Co., Ltd.), 0.96 parts of a compound represented by formula (5), and 5.9 parts of dimethyl sulfoxide (manufactured by Tokyo Chemical Industry Co., Ltd.) were mixed at room temperature, followed by temperature rise to 80°C and stirring for 6 hours. After the reaction liquid was cooled to room temperature, 75 parts of ion exchange water was charged to the reaction liquid. The obtained deposit was acquired as a residue of suction filtration, and washed with 75 parts of ethyl acetate (manufactured by FUJIFILM Wako Pure Chemical Corporation). Then, the resultant was dried under reduced pressure upon heating at 60°C to obtain 1.8 parts of a compound represented by formula (6).

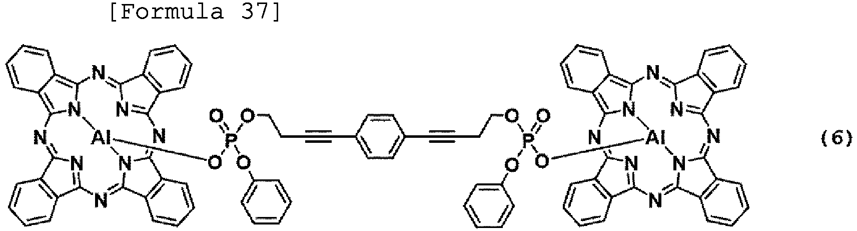

### Identification of compound represented by formula (6)

### (Mass spectrometry)

Ionization mode=MALDI-TOF⁻: m/z=1602.5
Exact Mass: 1602.3

### [Example 3]

In a reaction in which a compound represented by formula (2) of Example 1 is obtained, 1,3-diiodobenzene to be used was changed to 4,4'-diiodobiphenyl (manufactured by Tokyo Chemical Industry Co., Ltd.), to obtain a compound represented by formula (7).

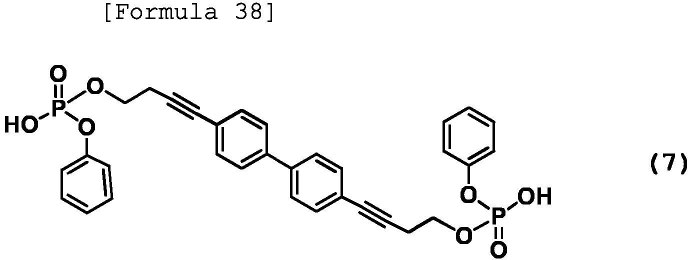

1.0 part of a compound represented by formula (3) (manufactured by Tokyo Chemical Industry Co., Ltd.), 0.52 parts of a compound represented by formula (7), and 5.0 parts of dimethyl sulfoxide (manufactured by Tokyo Chemical Industry Co., Ltd.) were mixed at room temperature, followed by temperature rise to 110°C and stirring for 6 hours. After the reaction liquid was cooled to room temperature, 25 parts of methanol (manufactured by FUJIFILM Wako Pure Chemical Corporation) was charged to the reaction liquid. The obtained deposit was acquired as a residue of suction filtration, and washed with 25 parts of methanol. Then, the resultant was dried under reduced pressure upon heating at 60°C to obtain 1.2 parts of a compound represented by formula (8) .

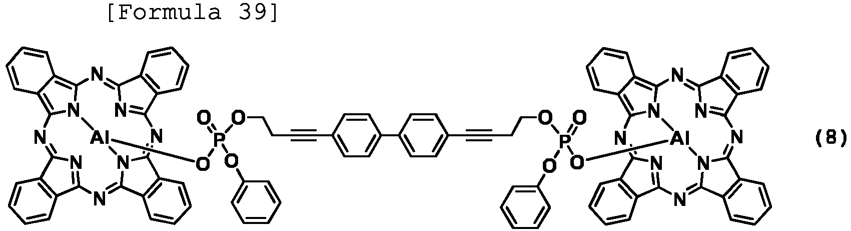

### Identification of compound represented by formula (8)

### (Mass spectrometry)

Ionization mode=MALDI-TOF⁺: m/z=[M+Na]+1701.2
Exact Mass: 1701.4

### [Example 4]

In a reaction in which a compound represented by formula (2) of Example 1 is obtained, 1,3-diiodobenzene to be used was changed to 2,7-diiodo-9,9-dimethylfluorene (manufactured by Tokyo Chemical Industry Co., Ltd.), to obtain a compound represented by formula (9).

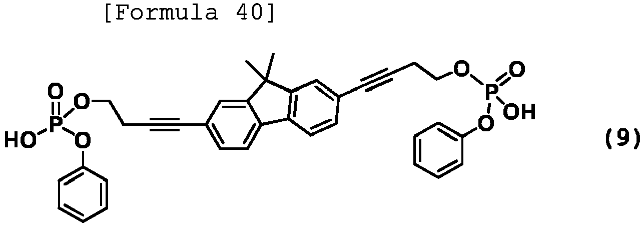

1.0 part of a compound represented by formula (3) (manufactured by Tokyo Chemical Industry Co., Ltd.), 0.56 parts of a compound represented by formula (9), and 5.0 parts of dimethyl sulfoxide (manufactured by Tokyo Chemical Industry Co., Ltd.) were mixed at room temperature, followed by temperature rise to 110°C and stirring for 6 hours. After the reaction liquid was cooled to room temperature, 25 parts of methanol (manufactured by FUJIFILM Wako Pure Chemical Corporation) was charged to the reaction liquid. The obtained deposit was acquired as a residue of suction filtration, and washed with 25 parts of methanol. Then, the resultant was dried under reduced pressure upon heating at 60°C to obtain 1.16 parts of a compound represented by formula (10) .

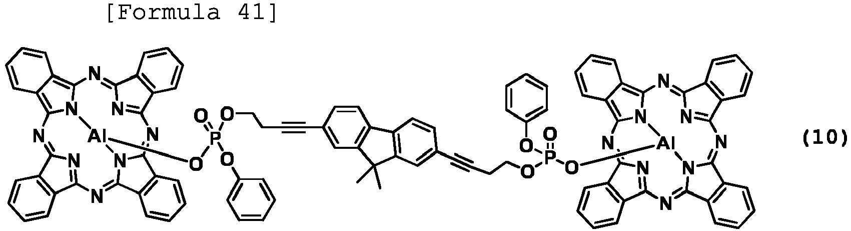

### Identification of compound represented by formula (10)

### (Mass spectrometry)

Ionization mode=MALDI-TOF⁺: m/z=[M+Na]⁺1741.2
Exact Mass: 1741.4

### [Example 5]

5.0 parts of 4-nitrophthalonitrile (manufactured by Tokyo Chemical Industry Co., Ltd.), 4.0 parts of ethanol (manufactured by FUJIFILM Wako Pure Chemical Corporation), 20 parts of potassium carbonate (manufactured by FUJIFILM Wako Pure Chemical Corporation), and 50 parts of N,N-dimethylformamide (manufactured by FUJIFILM Wako Pure Chemical Corporation) were mixed, followed by stirring at room temperature for 20 hours. Then, 100 parts of ion exchange water was charged to the mixture. The obtained deposit was acquired as a residue of suction filtration, and washed with 50 parts of ion exchange water. Then, the resultant was dried under reduced pressure upon heating at 60°C to obtain 4.0 parts of a compound represented by formula (11) .

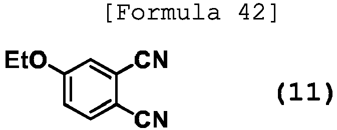

3.5 parts of a compound represented by formula (11), 0.9 parts of aluminum chloride (manufactured by FUJIFILM Wako Pure Chemical Corporation), 3.1 parts of diazabicycloundecene (manufactured by Tokyo Chemical Industry Co., Ltd.), and 18 parts of n-pentanol (manufactured by FUJIFILM Wako Pure Chemical Corporation) were mixed, and stirred under a refluxing condition for 30 hours. After the reaction liquid was cooled to room temperature, 36 parts of ethyl acetate was charged to the reaction liquid. The obtained deposit was acquired as a residue of suction filtration, and washed with 18 parts of ethyl acetate. 36 parts of ion exchange water was charged to the obtained residue, followed by stirring at room temperature for 0.5 hours. The obtained deposit was acquired as a residue of suction filtration, and washed with 18 parts of ion exchange water. Then, the resultant was dried under reduced pressure upon heating at 60°C to obtain 1.9 parts of a compound represented by formula (12) .

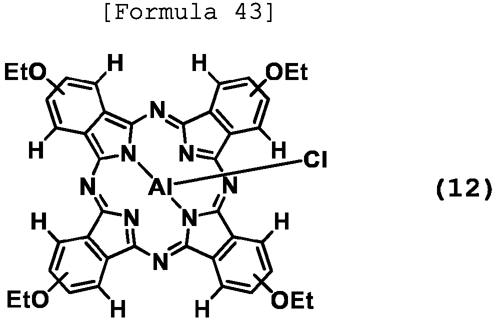

1.0 part of a compound represented by formula (12), 0.4 parts of compound represented by formula (7), and 5.0 parts of dimethyl sulfoxide (manufactured by Tokyo Chemical Industry Co., Ltd.) were mixed at room temperature, followed by temperature rise to 110°C and stirring for 12 hours. After the reaction liquid was cooled to room temperature, 25 parts of methanol (manufactured by FUJIFILM Wako Pure Chemical Corporation) was charged to the reaction liquid. The obtained deposit was acquired as a residue of suction filtration, and washed with 25 parts of methanol. Then, the resultant was dried under reduced pressure upon heating at 60°C to obtain 1.0 part of a compound represented by formula (13) .

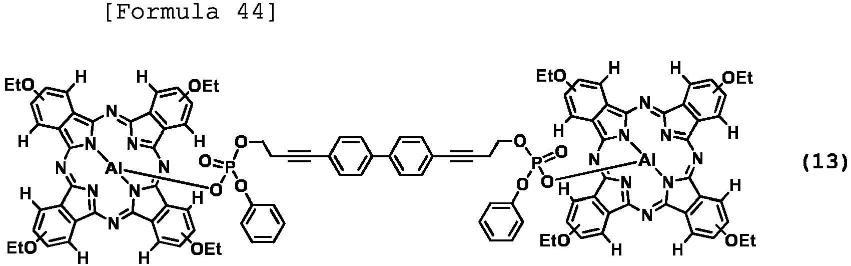

### Identification of compound represented by formula (13)

### (Mass spectrometry)

Ionization mode=MALDI-TOF⁻: m/z=2031.9
Exact Mass: 2032.0

### [Example 6]

A phthalonitrile derivative to be used was changed to 4-bromophthalonitrile according to the experimental section of page 651 of "Molecular organization in the thin films of chloroaluminium hexadecafluorophthalocyanine revealed by polarized Raman spectroscopy" (Thin Solid Films, 2013, Volume 548, 650-656) by Tamara V. Basova et al, to obtain a compound represented by a formula (14).

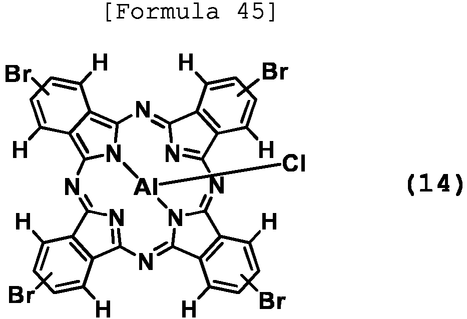

1.0 part of a compound represented by formula (14), 0.36 parts of a compound represented by formula (2), and 5.0 parts of dimethyl sulfoxide (manufactured by Tokyo Chemical Industry Co., Ltd.) were mixed at room temperature, followed by temperature rise to 110°C and stirring for 12 hours. After the reaction liquid was cooled to room temperature, 25 parts of methanol was charged to the reaction liquid. The obtained deposit was acquired as a residue of suction filtration, and washed with 25 parts of methanol. Then, the resultant was dried under reduced pressure upon heating at 60°C to obtain 1.2 parts of a compound represented by formula (15).

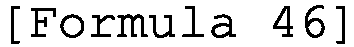

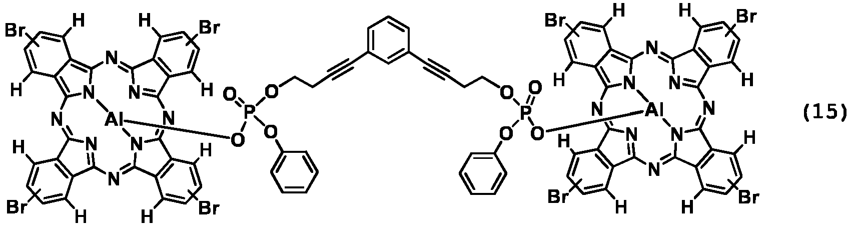

### Identification of compound represented by formula (15)

### (Mass spectrometry)

Ionization mode=MALDI-TOF⁻: m/z=2248.3
Exact Mass: 2248.6

### [Example 7]

1.0 part of a compound represented by formula (3) (manufactured by Tokyo Chemical Industry Co., Ltd.), 0.21 parts of 1,4-phenylenediphosphonic acid (manufactured by Tokyo Chemical Industry Co., Ltd.), and 5.0 parts of dimethyl sulfoxide (manufactured by Tokyo Chemical Industry Co., Ltd.) were mixed at room temperature, followed by temperature rise to 110°C and stirring for 6 hours. After the reaction liquid was cooled to room temperature, 25 parts of methanol (manufactured by FUJIFILM Wako Pure Chemical Corporation) was charged to the reaction liquid. The obtained deposit was acquired as a residue of suction filtration, and washed with 25 parts of methanol. Then, the resultant was dried under reduced pressure upon heating at 60°C to obtain 1.07 parts of a mixture of compounds represented by formula (16), formula (17), and formula (18) (hereinafter, mixture (1)).

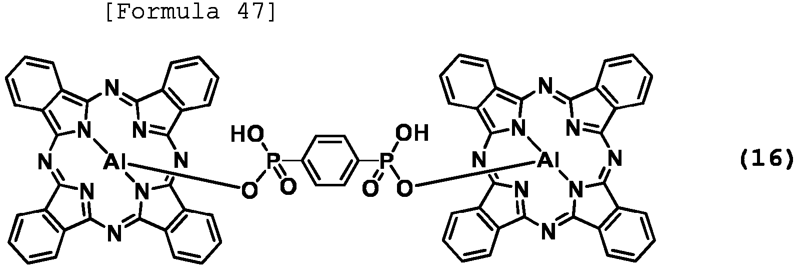

### Identification of compound represented by formula (16)

### (Mass spectrometry)

Ionization mode=MALDI-TOF⁺: m/z=[M+Na]⁺1337.0
Exact Mass: 1337.2

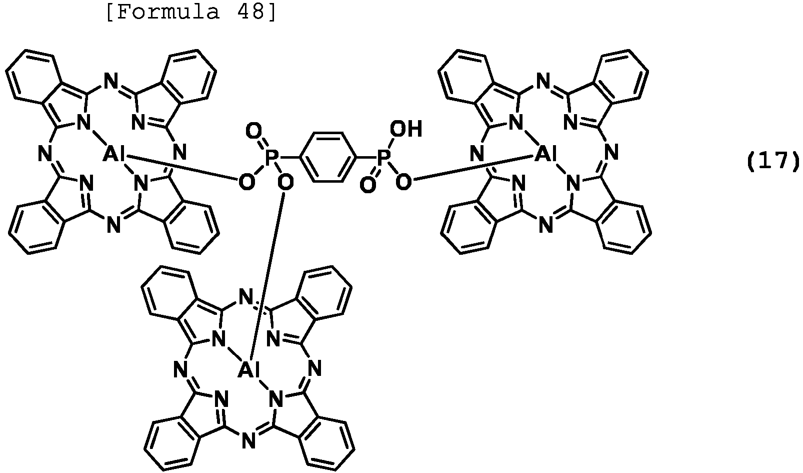

### Identification of compound represented by formula (17)

### (Mass spectrometry)

Ionization mode=MALDI-TOF⁺: m/z=[M+Na]⁺1875.1
Exact Mass: 1875.3

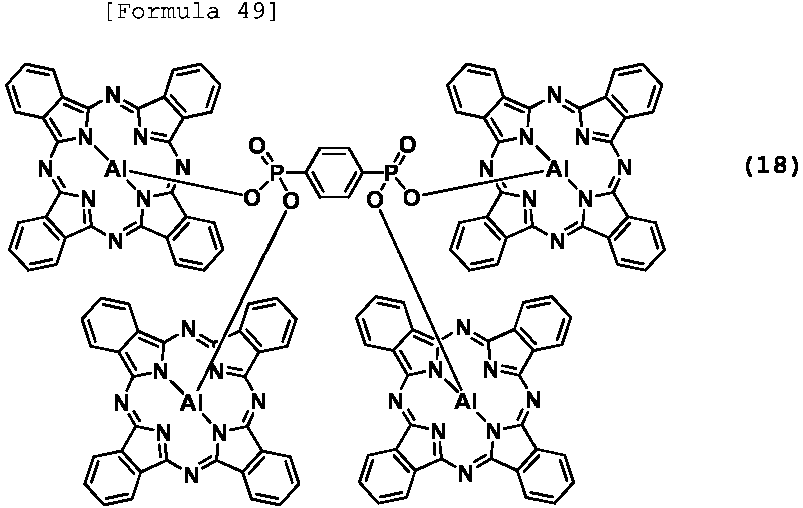

### Identification of compound represented by formula (18)

### (Mass spectrometry)

Ionization mode=MALDI-TOF⁺: m/z=[M+Na]⁺2413.1
Exact Mass: 2413.5

### [Comparative Example 1]

A compound represented by formula (x1) was obtained by the synthesis method described in Japanese Patent Laid-Open No. 2016-75837.

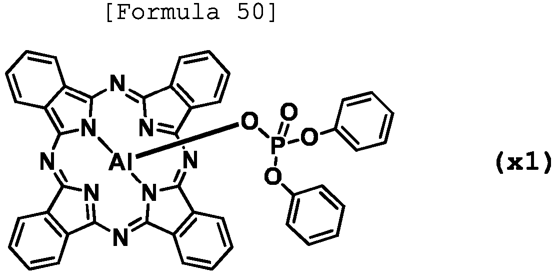

### [Measurement of Molar Absorption Coefficient]

The compound obtained in each of Examples 1 to 4, Examples 6 to 7, and Comparative Example 1 was diluted to 0.0280 g/L with N,N-dimethylformamide in a measuring flask. Then, UV-Vis measurement was carried out using a UV-Vis spectroscope (V-650, manufactured by JASCO Corporation), and a molar absorption coefficient in a maximum absorption wavelength (λmax) within a range of 600 to 750 nm was calculated. The results are shown in Table 6.

**[Table 6]**

| | Molar absorption coefficient (L·mol⁻¹·cm⁻¹) |
|---|---|
| Example 1 | 380517 |
| Example 2 | 326146 |
| Example 3 | 392865 |
| Example 4 | 468038 |
| Example 6 | 402187 |
| Example 7 | 398080 |
| Comparative Example 1 | 229396 |

### (Synthesis Example 1 of Resin)

A proper amount of nitrogen was flown into a flask equipped with a reflux condenser, a dropping funnel, and a stirrer to purge the inside of the flask with a nitrogen atmosphere. Then, 340 parts of propylene glycol monomethylether acetate was added into the flask, and then heated to 80°C while stirring. Subsequently, there was added dropwise, to the flask over 5 hours, a mixed solution containing 57 parts of acrylic acid, 54 parts of a mixture of 3,4-epoxytricyclo[5.2.1.0^{2,6}]decan-8-ylacrylate and 225 parts of 3,4-epoxytricyclo[5.2.1.0^{2,6}]decan-9-ylacrylate (the content ratio was 1:1 by mole), 239 parts of benzyl methacrylate, and 73 parts of propylene glycol monomethyl ether acetate. On the other hand, there was added dropwise, to the solution over 6 hours, a solution prepared by dissolving 40 parts of a polymerization initiator, 2,2-azo bis(2,4-dimethylvaleronitrile), in 197 parts of propylene glycol monomethylether acetate. After the completion of the dropwise addition of the polymerization initiator-containing solution, the solution was retained at 80°C for 3 hours, and then cooled to room temperature to obtain a copolymer (resin (B-1)) solution having a viscosity of 137 mPa•s as measured with a Type-B viscometer (23°C) and a solid content of 36.8% by weight. The produced copolymer had a weight average molecular weight of 1.0×10³ in terms of polystyrene, a degree of dispersion of 1.97, and an acid value of 111 mg-KOH/g in terms of solid content. The resin (B-1) has the following structural units.

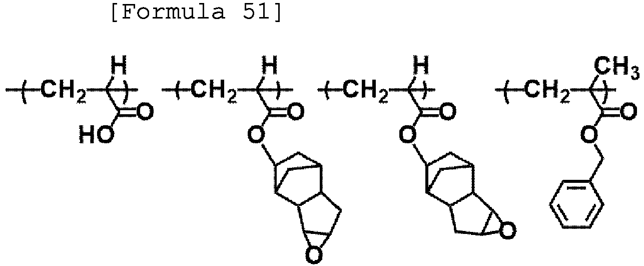

### (Preparation of Dispersion 1)

5.0 parts of a compound represented by formula (4), 3.0 parts of a dispersant (BYKLPN-6919, manufactured by BYK-Chemie Corporation), 3.0 parts of a resin (B-1) (in terms of solid content), and 89 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 1.

### (Preparation of Dispersion 2)

5.0 parts of a compound represented by formula (6), 3.0 parts of a dispersant (BYKLPN-6919, manufactured by BYK-Chemie Corporation), 3.0 parts of a resin (B-1) (in terms of solid content), and 89 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 2.

### (Preparation of Dispersion 3)

5.0 parts of a compound represented by formula (x1), 8.0 parts of a dispersant (BYKLPN-6919, manufactured by BYK-Chemie Corporation), 8.0 parts of a resin (B-1) (in terms of solid content), and 79 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 3.

### (Preparation of Dispersion 4)

5.00 parts of a compound represented by formula (4), 2.86 parts of a dispersant (BYKLPN-6919, manufactured by BYK-Chemie Corporation), 2.38 parts of a resin (B-1) (in terms of solid content), and 89.76 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 4.

### (Preparation of Dispersion 5)

12.02 parts of C. I. Pigment Blue 15:4, 3.61 parts of a dispersant (BYKLPN-6919, manufactured by BYK-Chemie Corporation), 5.41 parts of a resin (B-1) (in terms of solid content), 12.02 parts of diacetone alcohol, and 66.94 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 5.

### (Preparation of Dispersion 6)

12.0 parts of C. I. Pigment Blue 15:6, 2.2 parts of a dispersant (BYKLPN-6919, manufactured by BYK-Chemie Corporation), 5.6 parts of a resin (B-1) (in terms of solid content), 0.3 parts of diacetone alcohol, and 79.9 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 6.

### (Preparation of Dispersion 7)

12.0 parts of C. I. Pigment Yellow 150, 2.4 parts of a dispersant (BYKLPN-6919, manufactured by BYK-Chemie Corporation), 5.2 parts of a resin (B-1) (in terms of solid content), and 80.4 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 7.

### (Preparation of Dispersion 8)

10.0 parts of C. I. Pigment Yellow 185, 3.5 parts of a dispersant (BYKLPN-6919, manufactured by BYK-Chemie Corporation), 3.5 parts of a resin (B-1) (in terms of solid content), and 83.0 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 8.

### (Preparation of Dispersion 9)

5.0 parts of a compound represented by formula (8), 2.0 parts of a dispersant (BYKLPN-6919, manufactured by BYK-Chemie Corporation), 2.0 parts of a resin (B-1) (in terms of solid content), and 91.0 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 9.

### (Preparation of Dispersion 10)

5.0 parts of a compound represented by formula (10), 2.0 parts of a dispersant (BYKLPN-6919, manufactured by BYK-Chemie Corporation), 2.0 parts of a resin (B-1) (in terms of solid content), and 91.0 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 10.

### (Preparation of Dispersion 11)

5.0 parts of a compound represented by formula (15), 2.0 parts of a dispersant (BYKLPN-6919, manufactured by BYK-Chemie Corporation), 2.0 parts of a resin (B-1) (in terms of solid content), and 91.0 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 11.

### (Preparation of Dispersion 12)

5.0 parts of a mixture (1), 2.0 parts of a dispersant (BYKLPN-6919, manufactured by BYK-Chemie Corporation), 2.0 parts of a resin (B-1) (in terms of solid content), and 91.0 parts of propylene glycol monomethyl ether acetate were mixed. To the mixture, 300 parts of 0.4-mm zirconia beads were added, followed by shaking for 1 hour using a paint conditioner (manufactured by LAU Corporation). Then, the zirconia beads were removed by filtration to obtain a dispersion 12.

### [Examples 8 to 16 and Comparative Example 2]

### (Preparation of Colored Resin Composition)

Each colored resin composition was obtained by mixing components shown in Table 7.

**[Table 7]**

| Unit: part | | Example 8 | Example 9 | Example 10 | Example 11 | Example 12 | Example 13 | Example 14 | Example 15 | Example 16 | Comparative Example 2 |
|---|---|---|---|---|---|---|---|---|---|---|---|
| Dispersion | A-1 | 414.8 | | | | | | | | | |
| | A-2 | | 414.8 | | | | | | | | |
| | A-3 | | | | | | | | | | 516.9 |
| | A-4 | | | 200.9 | 198.7 | 200.4 | | | | | |
| | A-5 | | | 83.6 | | | | | | | |
| | A-6 | | | | 83.0 | | | | | | |
| | A-7 | | | | | 41.8 | | | | | |
| | A-8 | | | | | 50.0 | | | | | |
| | A-9 | | | | | | 399 | | | | |
| | A-10 | | | | | | | 399 | | | |
| | A-11 | | | | | | | | 399 | | |
| | A-12 | | | | | | | | | 399 | |
| Resin | B-1 | 47.6 | 47.6 | 50.7 | 50.6 | 51.3 | 52.0 | 52.0 | 52.0 | 52.0 | 18.6 |
| Polymerizable compound | C-1 | 20 | 20 | 20 | 20 | 20 | 20 | 20 | 20 | 20 | 20 |
| | C-2 | 20 | 20 | 20 | 20 | 20 | 20 | 20 | 20 | 20 | 20 |
| Polymerization initiator | D-1 | 5 | 5 | 5 | 5 | 5 | 5 | 5 | 5 | 5 | 5 |
| Solvent | E-1 | 645 | 645 | 599 | 581 | 578 | 320 | 320 | 320 | 320 | 855 |
| | E-2 | | | 137 | 145 | 147 | 293 | 293 | 293 | 293 | |
| Leveling agent | F-1 | 0.1 | 0.1 | 0.1 | 0.1 | 0.1 | 0.1 | 0.1 | 0.1 | 0.1 | 0.1 |

In Table 7, the components are as follows.
Dispersion (A-1): Dispersion 1
Dispersion (A-2): Dispersion 2
Dispersion (A-3): Dispersion 3
Dispersion (A-4): Dispersion 4
Dispersion (A-5): Dispersion 5
Dispersion (A-6): Dispersion 6
Dispersion (A-7): Dispersion 7
Dispersion (A-8): Dispersion 8
Dispersion (A-9): Dispersion 9
Dispersion (A-10): Dispersion 10
Dispersion (A-11): Dispersion 11
Dispersion (A-12): Dispersion 12
Resin (B-1): Resin (B-1) (in terms of solid content)
Polymerizable compound (C-1): "A-9550" (in terms of solid content), manufactured by Shin-Nakamura Chemical Co., Ltd.
Polymerizable compound (C-2): "A-TMPT" (in terms of solid content), manufactured by Shin-Nakamura Chemical Co., Ltd.
Polymerization initiator (D-1): N-acetyloxy-1-(4-phenylsulfanylphenyl)-3-cyclohexylpropane-1-one-2-imine ("TR-PBG-327", manufactured by Changzhou Tronly New Electronic Materials Co., Ltd.)
Solvent (E-1): Propylene glycol monomethyl ether acetate
Solvent (E-2): Diacetone alcohol
Leveling agent (F-1): Polyether modified silicone oil: trade name Toray silicone SH8400, manufactured by Toray Dow Corning Co., Ltd. (in terms of solid content)

In each of Examples 8 to 16 and Comparative Example 2, the solid content of the colored resin composition was 12.0%. In the colored resin composition of each of Examples 8 to 16 and Comparative Example 2, the content rate of the colorant was 15.0% in the solid content of the colored resin composition.

### (Preparation of Color Filter (Colored Coating Film))

Each of colored resin compositions was applied onto a 5-cm square glass substrate (EAGLE 2000; manufactured by Corning Incorporated) by a spin coating method, and then prebaked at 90°C for 2 minutes to form a colored composition layer. After the colored composition layer was allowed to cool, the colored composition layer was irradiated with light at an exposure amount of 1000 mJ/cm² (reference: 365 nm) under an air atmosphere using an exposure machine (TME-150RSK; manufactured by Topcon Corporation). Then, the colored composition layer was post-baked by a hot plate at 220°C for 5 minutes, to obtain a color filter.

### [Spectral Evaluation]

The spectrum of the obtained color filter was measured at intervals of 5 nm using a colorimeter (OSP-SP-200, manufactured by Olympus Corporation), and a spectrum after pre-baking, and a spectrum after post-baking were respectively obtained. A wavelength (visible side T50 wavelength) representing a 50% wavelength of a maximum transmittance in the obtained spectrum data and present in a visible light range (400 to 700 nm) was obtained, and a half-value shift before and after post-baking was calculated based on the following formula. The results are shown in Table 8. It can be said that as the half-value shift is smaller, stability before and after post-baking is better. Even a small shift in the visible side T50 wavelength between before and after post-baking affects a color gamut (the target chromaticity cannot be attained). Therefore, the colored resin composition of the present invention in which the half-value shift can be reduced to 5 nm or less (particularly, 3 nm or less or 1 nm or less) can be said to be very significant in the field of the color filter. Half-value shift (nm) = |visible side T50 wavelength after pre-baking - visible side T50 wavelength after post-baking|

When the visible side T50 wavelength is present between two measurement points, the visible side T50 wavelength is optionally calculated using a TREND function from the measured values of transmissivities at the two measurement points.

**[Table 8]**

| | Half-value shift |
|---|---|
| Example 8 | 0 nm |
| Example 9 | 1 nm |
| Example 10 | 0 nm |
| Example 11 | 1 nm |
| Example 12 | 4 nm |
| Example 13 | 5 nm |
| Example 14 | 0 nm |
| Example 15 | 3 nm |
| Example 16 | 1 nm |
| Comparative Example 2 | 7 nm |

## Claims

1. A compound represented by formula (I): 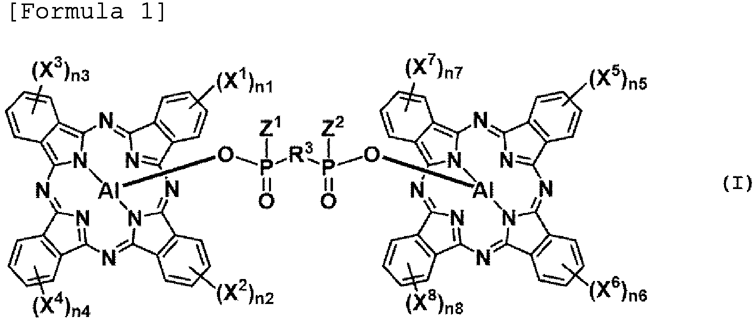 wherein
X¹ to X⁸ each independently represent -R⁴, -OR⁴, -SR⁴, a halogen atom, a nitro group, or a sulfamoyl group optionally having a substituent,
R⁴ represents a hydrocarbon group having 1 to 20 carbon atoms and optionally having a substituent,
n1 to n8 each independently represent an integer of 0 to 4,
Z¹ and Z² each independently represent a group represented by formula (i),
R³ represents a hydrocarbon group optionally having a substituent, an aromatic heterocyclic group optionally having a substituent, or a group in which a hydrocarbon group optionally having a substituent and an aromatic heterocyclic group optionally having a substituent are combined, and -CH₂- contained in the hydrocarbon group is optionally replaced with -O-, -CO-, -NR⁶-, -S-, -SO-, or -SO₂-, and
R⁶ represents a hydrogen atom or an alkyl group having 1 to 4 carbon atoms, 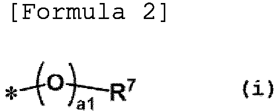 wherein
R⁷ represents a hydrogen atom, a hydrocarbon group optionally having a substituent, or a group represented by formula (ii),
a1 represents 0 or 1, and
* represents a bond, 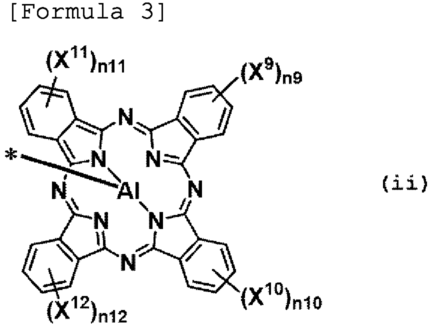 wherein
X⁹ to X¹² each independently represent -R⁵, -OR⁵, - SR⁵, a halogen atom, a nitro group, or a sulfamoyl group optionally having a substituent,
R⁵ represents a hydrocarbon group having 1 to 20 carbon atoms and optionally having a substituent,
n9 to n12 each independently represent an integer of 0 to 4, and
* represents a bond.

2. A colored resin composition comprising the compound according to claim 1 and a resin.

3. The colored resin composition according to claim 2, comprising a polymerizable compound and a polymerization initiator.

4. A color filter formed from the colored resin composition according to claim 2 or 3.

5. A display device comprising the color filter according to claim 4.
